# EUROPEAN PATENT APPLICATION

(11) **EP 4 776 779 A1**
(43) Date of publication of application: **15.07.2026**
(21) Application number: 25211294.1
(22) Date of filing: 27.10.2025
(51) Int. Cl.: H10B 12/00, H10B 80/00, H10W 80/00

(54) **SEMICONDUCTOR MEMORY DEVICE AND METHOD FOR FABRICATING THE SAME**

(30) Priority: 08.01.2025 KR 20250002545; 29.07.2025 KR 20250103348
(71) Applicant: Samsung Electronics Co., Ltd., Suwon-si, Gyeonggi-do 16677 (KR)
(72) Inventor: KO, Seung-Bo, 16677 Suwon-si, Gyeonggi-do (KR); LEE, Ki Seok, 16677 Suwon-si, Gyeonggi-do (KR); KIM, Jong Min, 16677 Suwon-si, Gyeonggi-do (KR); KIM, Cha Hee, 16677 Suwon-si, Gyeonggi-do (KR); KIM, Taehoon, 16677 Suwon-si, Gyeonggi-do (KR)
(74) Representative: Kuhnen & Wacker Patent- und Rechtsanwaltsbüro PartG mbB

(57) **Abstract**

A semiconductor memory device includes a memory cell structure (MC) which includes a channel pattern (CH), a bit line (BL) connected to a first portion of the channel pattern (CH), a data storage structure (CAP) connected to a second portion of the channel pattern (CH), and a word line (WL) intersecting the channel pattern (CH) between the first portion and the second portion, a substrate (200) which faces the memory cell structure (MC) in a first direction, the substrate (200) including a first region (I) and a second region (II) different from each other, a first insulation pattern (DI1) which defines an active region (AR1 to AR3) inside the first region (I), an active pattern (AP1 to AP3) which protrudes from the active region (AR1 to AR3), a gate structure (GS) which intersects the active pattern (AP1 to AP3), on the active pattern (AP1 to AP3), a second insulation pattern (DI2) inside the second region (II), and a through via (TV) which extends in the first direction and penetrates the second insulation pattern (DI2).

## Description

### BACKGROUND

### 1. Technical Field

The present inventive concept relates to a semiconductor memory device and a method for fabricating the same. More specifically, the present inventive concept relates to a semiconductor memory device having a POC (Peri On Cell) structure and a method for fabricating the same.

### 2. Description of the Related Art

As semiconductor memory devices gradually become more highly integrated, individual circuit patterns are further miniaturized to implement more semiconductor memory devices in the same area. However, the miniaturization of the individual circuit patterns increase the difficulty of the process and cause defects. As a result, various methods for fabricating a semiconductor memory device with better performance while overcoming the limitations associated with the high integration of the semiconductor memory device are being researched. For example, a so-called POC (Peri On Cell) structure is suggested in which a peripheral circuit structure is stacked on a cell structure has been proposed to increase the high integration of the semiconductor memory device.

### SUMMARY

Aspects of the present inventive concept provide a semiconductor memory device having improved performance and integration.

Aspects of the present inventive concept also provide a method for fabricating a semiconductor memory device having improved performance and integration.

However, aspects of the present inventive concept are not restricted to the one set forth herein. The above and other aspects of the present inventive concept will become more apparent to one of ordinary skill in the art to which the present inventive concept pertains by referencing the detailed description of the present inventive concept given below.

According to an aspect of the present inventive concept, there is provided a semiconductor memory device comprising a memory cell structure which includes a channel pattern, a bit line connected to a first portion of the channel pattern, a data storage structure connected to a second portion of the channel pattern, and a word line intersecting the channel pattern between the first portion and the second portion, a substrate which faces the memory cell structure in a first direction, the substrate including a first region and a second region different from each other, a first insulation pattern which defines an active region inside the first region, an active pattern which protrudes from the active region, a gate structure which intersects the active pattern, on the active pattern, a second insulation pattern inside the second region, and a through via which extends in the first direction and penetrates the second insulation pattern.

According to an aspect of the present inventive concept, there is provided a semiconductor memory device comprising a memory cell structure which includes a channel pattern, a bit line connected to a first portion of the channel pattern, a data storage structure connected to a second portion of the channel pattern, and a word line intersecting the channel pattern between the first portion and the second portion, a substrate which faces the memory cell structure in a first direction, the substrate including a first region and a second region different from each other, a first insulation pattern which defines an active region inside the first region, an active pattern which protrudes from the active region, a field insulation film which covers at least a part of a side face of the active pattern, on the active region, a second insulation pattern inside the second region, and a through via which extends in the first direction and penetrates the second insulation pattern, wherein the first insulation pattern and the second insulation pattern have materially the same compositions.

According to an aspect of the present inventive concept, there is provided a semiconductor memory device comprising a memory cell structure which includes a channel pattern, a bit line connected to a first portion of the channel pattern, a data storage structure connected to a second portion of the channel pattern, and a word line intersecting the channel pattern between the first portion and the second portion, a substrate which faces the memory cell structure in a first direction, the substrate including a first region and a second region different from each other, a first insulation pattern which separates a first active region and a second active region, inside the first region, a first active pattern which protrudes from the first active region, a first source/drain pattern which is connected to the first active pattern, the first source/drain pattern having a first conductivity type, a second active pattern which protrudes from the second active region, a second source/drain pattern which is connected to the second active pattern, the second source/drain pattern having a second conductivity type different from the first conductivity type, a second insulation pattern inside the second region, a through via which extends in the first direction and penetrates the second insulation pattern, a spacer which extends along at least a part of the first insulation pattern, the second region, and at least a part of the second insulation pattern, and an etch stop film which extends along the first source/drain pattern, the second source/drain pattern, the spacer, the first insulation pattern, and the second insulation pattern, wherein a thickness of the spacer on the first insulation pattern is equal to a thickness of the spacer on the second insulation pattern, and a thickness of the etch stop film on the first insulation pattern is equal to a thickness of the etch stop film on the second insulation pattern.

### BRIEF DESCRIPTION OF THE DRAWINGS

The above and other aspects and features of the present inventive concept will become more apparent by describing in detail exemplary embodiments thereof with reference to the attached drawings, in which:
FIG. 1 is an exemplary layout diagram for explaining a semiconductor memory device according to example embodiments.
FIG. 2 is an enlarged view for explaining a region R1 of FIG. 1 according to example embodiments.
FIG. 3 is an exemplary layout diagram for explaining a peripheral circuit region of FIGS. 1 and 2 according to example embodiments.
FIG. 4 is a cross-sectional view taken along A-A, B-B, and C-C of FIG. 3 according to example embodiments.
FIGS. 5 to 11 are various enlarged views for explaining regions R2a, R2b, and R2c of FIG. 4 according to example embodiments.
FIGS. 12 to 17 are various cross-sectional views for explaining a semiconductor memory device according to example embodiments.
FIGS. 18 to 34 are intermediate step diagrams for describing the method for fabricating the semiconductor memory device according to example embodiments.
FIGS. 35 and 36 are intermediate step diagrams for explaining the method for fabricating a semiconductor memory device according to example embodiments.
FIGS. 37 to 39 are intermediate step diagrams for explaining the method for fabricating a semiconductor memory device according to example embodiments.
FIG. 40 is an intermediate step diagram for explaining the method for fabricating the same of the semiconductor memory device according to example embodiments.

### DETAILED DESCRIPTION OF THE EMBODIMENTS

It will be understood that, although the terms first, second, etc. may be used herein to describe various elements, these elements should not be limited by these terms. These terms are only used to distinguish one element from another element. Thus, for example, a first element, a first component or a first section discussed below could be termed a second element, a second component or a second section without departing from the teachings of the present inventive concept.

Spatially relative terms, such as "beneath," "below," "lower," "above," "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the exemplary term "below" can encompass both an orientation of above and below. The device may be otherwise oriented (rotated 90 degrees or at other orientations) and the spatially relative descriptors used herein interpreted accordingly.

The term "same" means not only exactly the same thing but also includes a slight difference that may occur due to a process margin or the like.

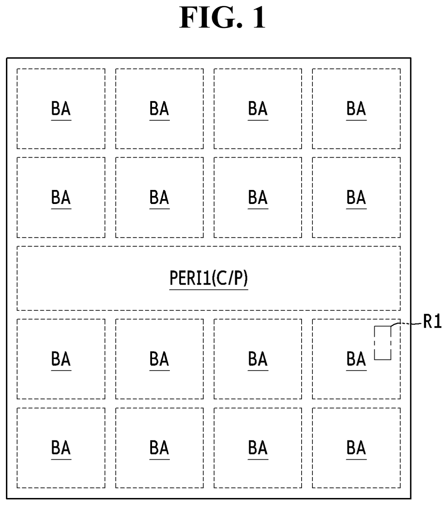

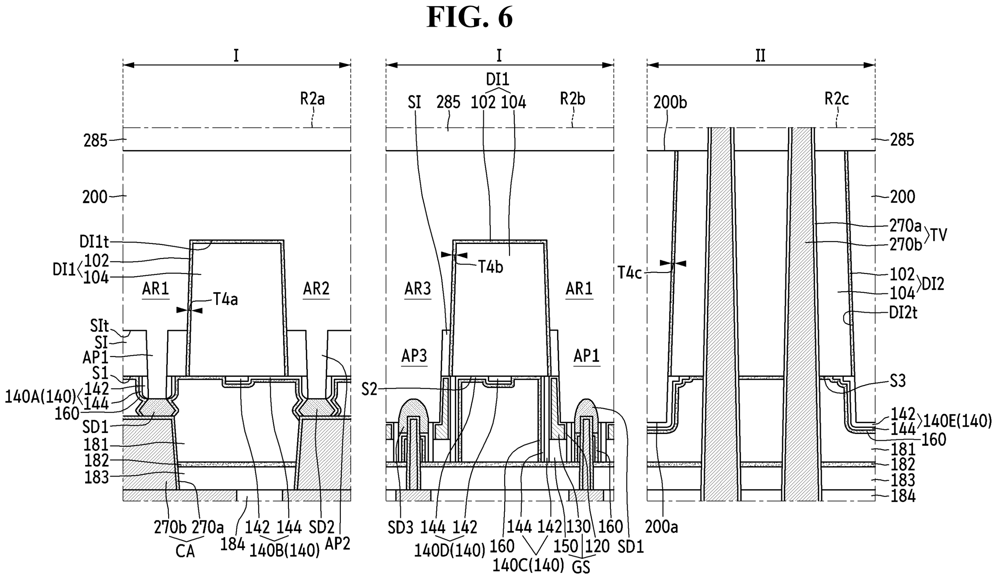

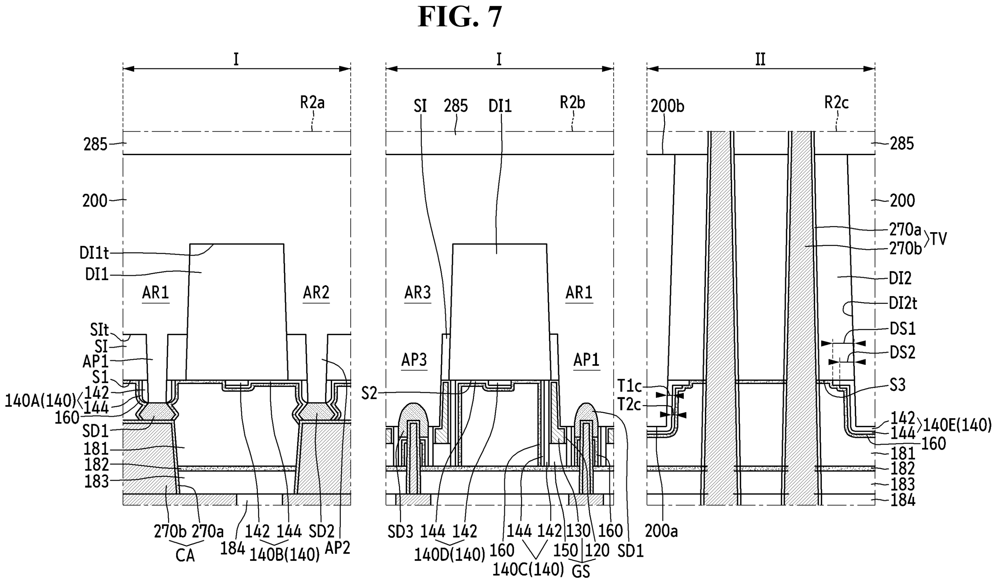

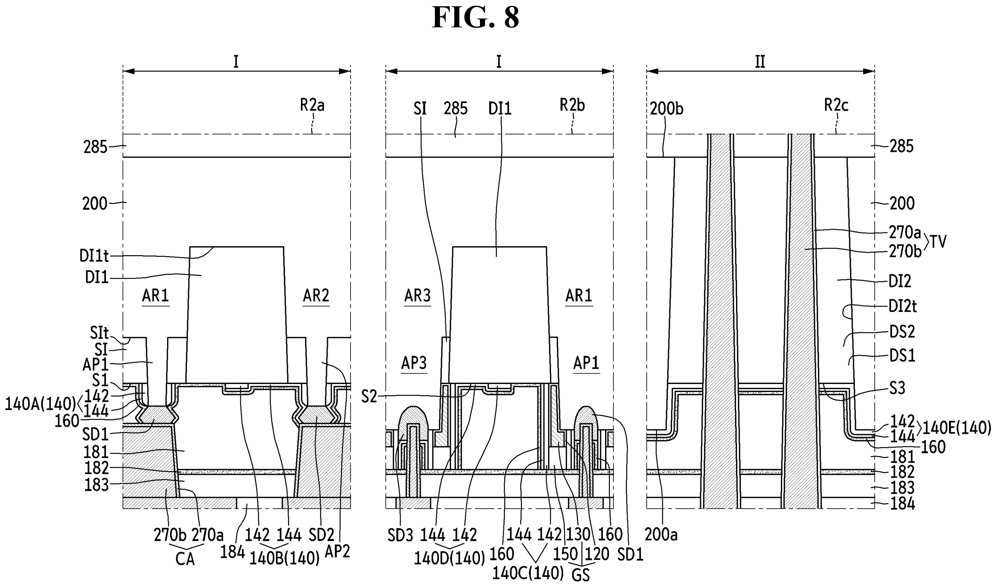

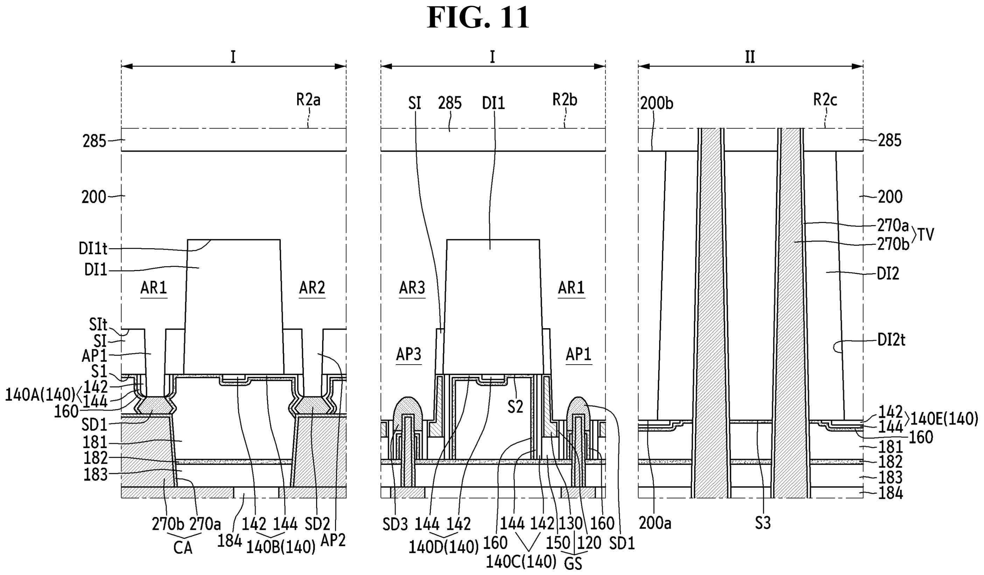

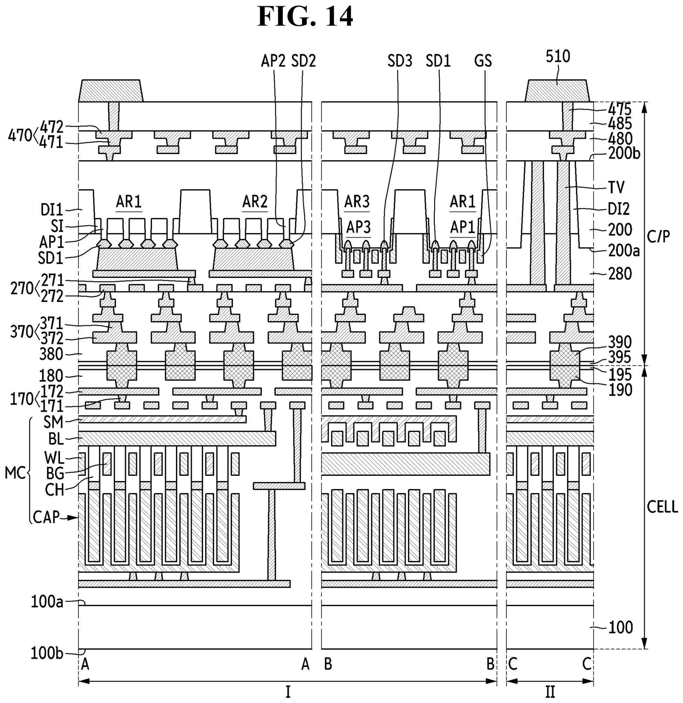

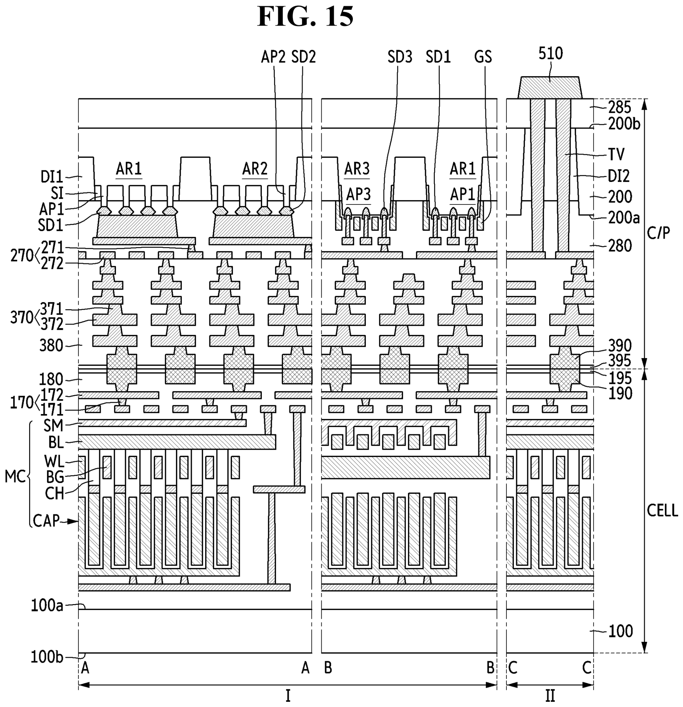

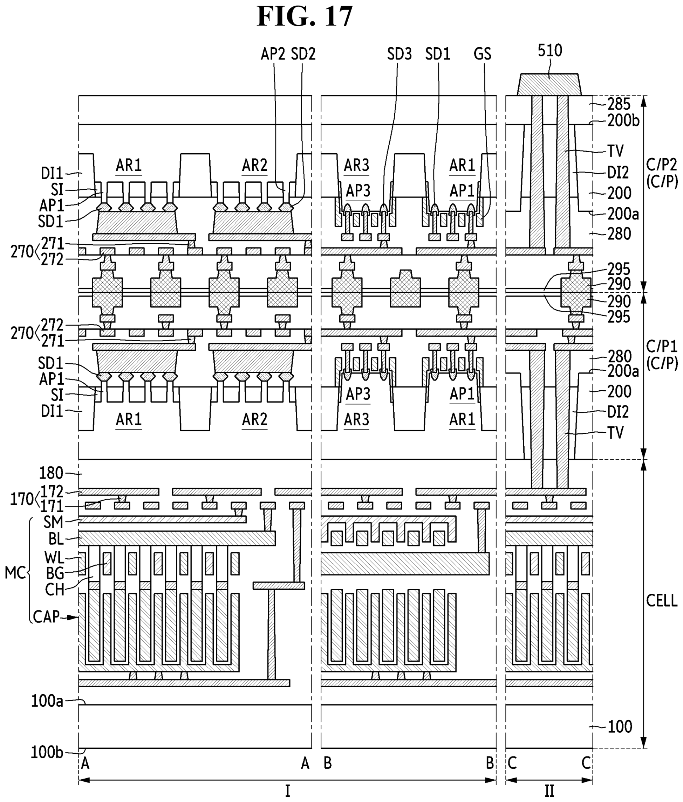

Hereinafter, a semiconductor memory device according to exemplary embodiments will be described referring to FIGS. 1 to 17.

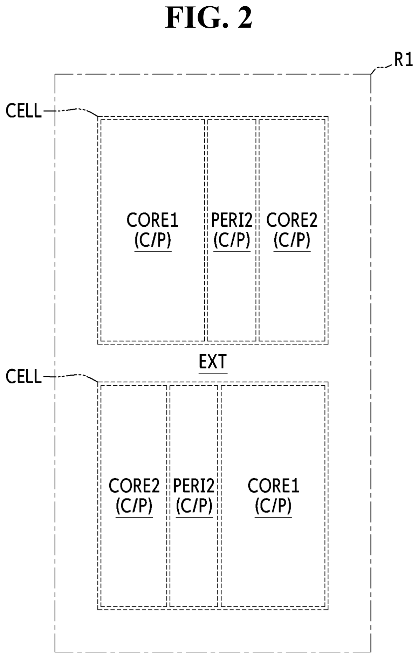

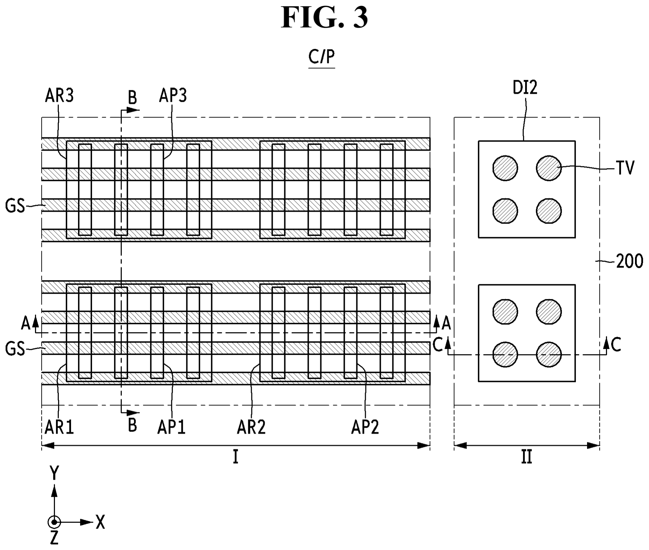

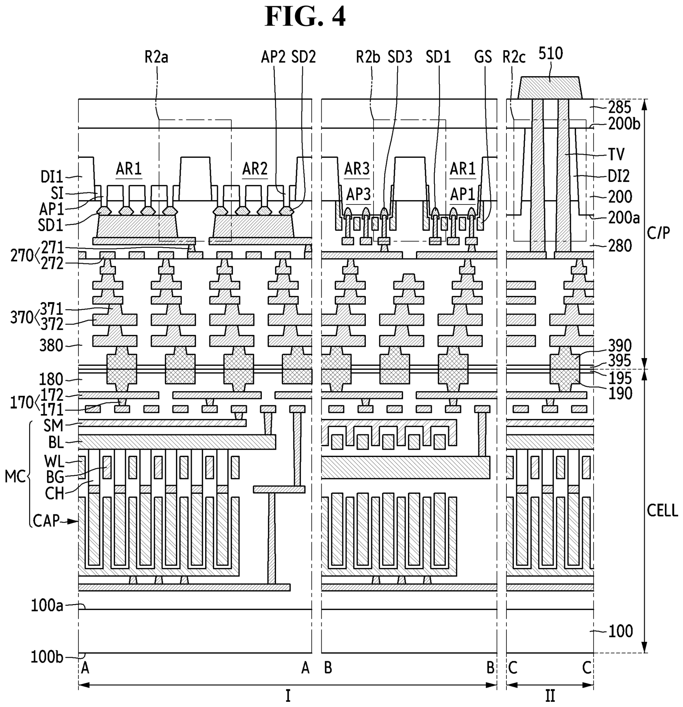

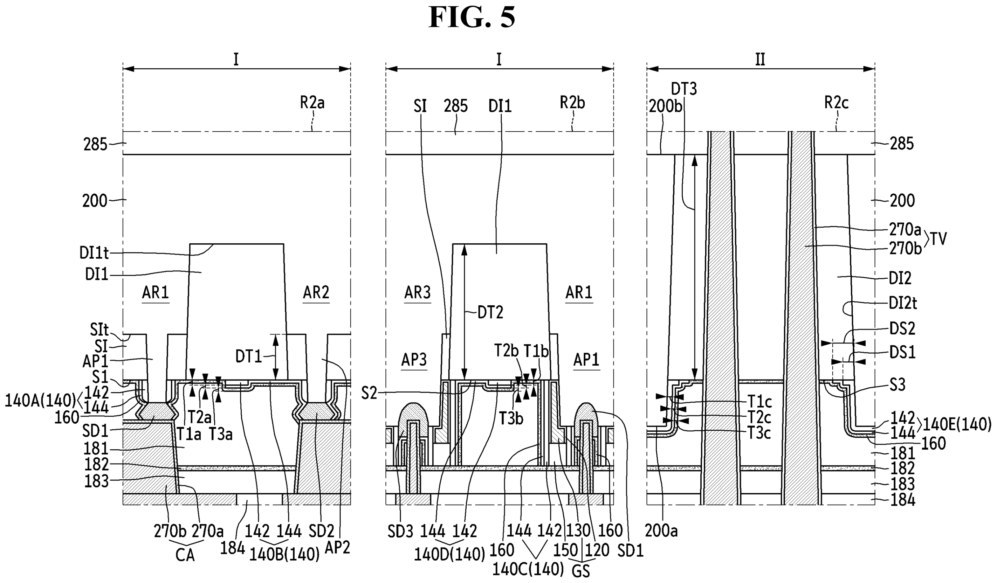

FIG. 1 is an exemplary layout diagram for explaining a semiconductor memory device according to example embodiments. FIG. 2 is an enlarged view for explaining a region R1 of FIG. 1 according to example embodiments. FIG. 3 is an exemplary layout diagram for explaining a peripheral circuit region of FIGS. 1 and 2 according to example embodiments. FIG. 4 is a cross-sectional view taken along A-A, B-B, and C-C of FIG. 3 according to example embodiments. FIGS. 5 to 11 are various enlarged views for explaining regions R2a, R2b, and R2c of FIG. 4 according to example embodiments.

Referring to FIGS. 1 and 2, the semiconductor memory device according to some embodiments includes a plurality of bank regions BA and a peripheral circuit region C/P.

Each bank region BA may include a cell region CELL and an extension region EXT. The cell region CELL may include a memory cell structure MC to be described below. The extension region EXT may be adjacent to the cell region CELL. For example, the extension region EXT may surround the periphery of the cell region CELL.

The peripheral circuit region C/P may include various peripheral circuits that control the operation of the cell region CELL. At least a part of the peripheral circuit region C/P may overlap the cell region CELL. For example, the peripheral circuit region C/P may include a first peri-region PERI1, a second peri-region PERI2, a first core region CORE1, and a second core region CORE2. The first peri-region PERI1 may be disposed between the bank regions BA. The second peri-region PERI2, the first core region CORE1, and the second core region CORE2 may be stacked on the cell region CELL.

Each of the first peri-region PERI1 and the second peri-region PERI2 may include peripheral circuits for inputting/outputting, for example, data or a commander, or for inputting power/ground.

The second peri-region PERI2 may be disposed between the first core region CORE1 and the second core region CORE2. The first core region CORE1 may include, for example, sense amplifiers for sensing a voltage change of a bit line BL to be described below. The second core region CORE2 may include, for example, sub-word line drivers for controlling a word line WL to be described below.

Referring to FIGS. 1 to 5, the semiconductor memory device according to some embodiments includes a cell region CELL and a peripheral circuit region C/P that are stacked along a first direction Z.

The cell region CELL may include a first substrate 100, a memory cell structure MC, a first wiring structure 170, and a first insulation structure 180.

The first substrate 100 may be bulk silicon or silicon-on-insulator (SOI). The first substrate 100 may be a silicon substrate, or may include other materials, for example, silicon germanium, gallium arsenide, silicon germanium on insulator (SGOI), indium antimonide, lead telluride, indium arsenide, indium phosphide or gallium antimonide. Alternatively, the first substrate 100 may be a base substrate having an epitaxial layer formed thereon, and may be a ceramic substrate, a quartz substrate, a glass substrate for a display or the like.

The first substrate 100 may include a first side 100a and a second side 100b that are opposite to each other in the first direction Z. In the following description, the first side 100a may also be referred to as a front side of the first substrate 100, and the second side 100b may also be referred to as a back side of the first substrate 100.

The memory cell structure MC may be disposed on the first side 100a of the first substrate 100. In some embodiments, the memory cell structure MC may include unit memory cells of a dynamic random access memory (DRAM). In the following description, DRAM cells including a vertical channel transistor (VCT) are described as the memory cell structure MC. However, this is merely an example, and the memory cell structure MC may include various other DRAM cells, for example, at least one of DRAM cells including a PCAT (Planar Channel Array Transistor), DRAM cells including a RCAT (Recessed Channel Array Transistor), DRAM cells including a BCAT (Buried Channel Array Transistor) and/or combinations thereof.

In some embodiments, the memory cell structure MC may include a plurality of channel patterns CH, word lines WL, bit lines BL, and a data storage structure CAP.

The plurality of channel patterns CH may be arranged two-dimensionally along a horizontal plane that intersects the first direction Z. For example, the channel patterns CH may be arranged in a matrix shape along a second direction Y and a third direction X that intersect each other. Each channel pattern CH may extend long in the first direction Z.

Each of the channel patterns CH may include a semiconductor material. For example, each of the channel patterns CH may include an elemental semiconductor material such as monocrystalline silicon (monocrystalline Si), polycrystalline silicon (polycrystalline Si), amorphous silicon (amorphous Si), silicon germanium (SiGe), silicon germanium on insulator (SGOI), indium antimonide, lead telluride, indium arsenide, indium phosphide, gallium arsenide or gallium antimonide.

The word line WL may be disposed on the side faces of each channel pattern CH. The word line WL may intersect each channel pattern CH. For example, the word line WL may extend long in the second direction Y that intersects the first direction Z. The plurality of word lines WL are spaced apart from each other, and may extend side by side.

In some embodiments, the memory cell structure MC may further include a back gate electrode BG. The back gate electrode BG may be disposed on the side faces of each channel pattern CH. The back gate electrode BG may intersect each channel pattern CH. For example, the back gate electrode BG may extend long in the second direction Y. Each channel pattern CH may be interposed between the word line WL and the back gate electrode BG. For example, the word line WL may be disposed on one side face of each channel pattern CH, and the back gate electrode BG may be disposed on the other side face of each channel pattern CH.

The bit line BL may be connected to a first portion (e.g., an upper part) of each channel pattern CH. The bit line BL may intersect the word line WL. For example, the bit line BL may extend long in a third direction X that intersects the first direction Z and the second direction Y. The plurality of bit lines BL are spaced apart from each other and may extend side by side.

In some embodiments, the memory cell structure MC may further include a shield conductive film SM. At least a part of the shield conductive film SM may be interposed between the plurality of bit lines BL. The shield conductive film SM may be used to reduce coupling noise between adjacent bit lines BL.

The data storage structure CAP may be connected to the second portion (e.g., a lower part) of each channel pattern CH. The word line WL may intersect each channel pattern CH between the first portion and the second portion. The data storage structure CAP may be controlled by the word line WL and the bit line BL to store data in the unit memory cell corresponding to each channel pattern CH. In some embodiments, the data storage structure CAP may be a capacitor.

The first insulation structure 180 may be disposed on the first side 100a of the first substrate 100. The first insulation structure 180 may cover the memory cell structure MC. Although the first insulation structure 180 is shown as a single film, this is merely an example, and the first insulation structure 180 may be a multi-insulation film including a plurality of insulation films. The first insulation structure 180 may include, for example, but is not limited to, at least one of silicon oxide, silicon oxynirtide, and a low-k material having a dielectric constant lower than that of silicon oxide.

The first wiring structure 170 may be formed in the first insulation structure 180. The first wiring structure 170 may provide an electrical path connected to the memory cell structure MC. For example, the first wiring structure 170 may include first wiring patterns 172 of a multi-layer structure, and first via patterns 171 that interconnect the first wiring patterns 172 of different layers from each other. The number of layers, number, shape, placement, and the like of the first wiring structure 170 are merely an example and are not limited to those shown in the drawings.

The peripheral circuit region C/P may include a second substrate 200, a first insulation pattern DI1, a second insulation pattern DI2, active patterns AP1 to AP3, a field insulation film SI, gate structures GS, a spacer 140, source/drain patterns SD1 to SD3, a first etch stop film 160, a second interlayer insulation film 183, a source/drain contact CA, a through via TV, a second wiring structure 270, a second insulation structure 280, a front wiring structure 370, a front inter-wiring insulation film 380, and a first back insulation film 285.

The second substrate 200 may be a semiconductor substrate, for example, bulk silicon or silicon-on-insulator (SOI). The second substrate 200 may be a silicon substrate or may include other materials, for example, but is not limited to, at least one of silicon germanium, gallium arsenide, silicon germanium on insulator (SGOI), indium antimonide, lead telluride, indium arsenide, indium phosphide, gallium antimonide, and/or combinations thereof.

The second substrate 200 may include a third side 200a and a fourth side 200b that are opposite to each other in the first direction Z. In the following description, the third side 200a may be referred to as the front side of the second substrate 200, and the fourth side 200b may be referred to as the back side of the second substrate 200.

The second substrate 200 may include a first region I and a second region II that are different from each other. The first region I and the second region II may be regions adjacent to each other, and may be regions spaced apart from each other.

The first region I of the second substrate 200 may include a plurality of active regions AR1 to AR3. For example, the second substrate 200 may include a first active region AR1, a second active region AR2, and a third active region AR3. The first active region AR1 and the second active region AR2 may be arranged along the third direction X. The first active region AR1 and the third active region AR3 may be arranged along the second direction Y.

In some embodiments, transistors of different conductivity types may be formed on the first active region AR1 and the second active region AR2. In some embodiments, transistors of different conductivity types may be formed on the first active region AR1 and the third active region AR3. The following description shows an example in which the first active region AR1 is an N-type field-effect transistor (NFET) region, and each of the second active region AR2 and the third active region AR3 is a PFET region. However, this is merely an example, and it goes without saying that the first active region AR1 may be a P-type FET (PFET) region, and each of the second active region AR2 and the third active region AR3 may be a NFET region. In an embodiment, the transistor in the first region I may be a fin-shape FET (FinFET) or a three-dimensional FET, in which a gate structure GS is provided to surround a channel pattern of the transistor.

The first insulation pattern DI1 may be formed in the first region I of the second substrate 200. The first insulation pattern DI1 may define a plurality of active regions AR1 to AR3 in the second substrate 200. For example, a first separation trench DI1t that defines the plurality of active regions AR1 to AR3 may be formed in the first region I of the second substrate 200. The first insulation pattern DI1 may fill at least a part of the first separation trench DI1t. The first insulation pattern DI1 may surround side faces of each of the active regions AR1 to AR3. The active regions AR1 to AR3 may be separated from each other by the first insulation pattern DI1.

In some embodiments, a width of the first insulation pattern DI1 may decrease toward the fourth side 200b. This may be due to the fact that the etching process for forming the first separation trench DI1t is performed in a direction from the third side 200a toward the fourth side 200b.

The second insulation pattern DI2 may be formed in the second region II of the second substrate 200. The second insulation pattern DI2 may define an insulation region in the second region II of the second substrate 200. For example, a second separation trench DI2t penetrating the second substrate 200 may be formed in the second region II of the second substrate 200. The second insulation pattern DI2 may fill at least a part of the second separation trench DI2t.

In some embodiments, the width of the second insulation pattern DI2 may decrease toward the fourth side 200b. This may be due to the fact that etching process for forming the second separation trench DI2t is performed in a direction from the third side 200a toward the fourth side 200b.

In some embodiments, the second insulation pattern DI2 may be spaced apart from the third side 200a of the second region II. For example, as shown in FIG. 5, a part of the second region II of the second substrate 200 may protrude below the surface S3 (e.g., the lower side) of the second insulation pattern DI2.

In some embodiments, the second insulation pattern DI2 may be in contact with the fourth side 200b of the second region II. For example, as shown in FIG. 5, the upper side of the second insulation pattern DI2 may be disposed to be coplanar with the fourth side 200b of the second substrate 200.

The first insulation pattern DI1 and the second insulation pattern DI2 may be formed at the same level. In this specification, "the same level" means that the insulation patterns are formed by the same fabricating process. For example, the first insulation pattern DI1 and the second insulation pattern DI2 may have materially the same compositions as each other.

Each of the first insulation pattern DI1 and the second insulation pattern DI2 may include, but are not limited to, for example, at least one of silicon nitride, silicon oxynitride, silicon oxycarbide, silicon boron nitride, silicon boron carbonitride, silicon oxycarbonitride and/or a combination thereof. As an example, each of the first insulation pattern DI1 and the second insulation pattern DI2 may include a silicon oxide film.

The active patterns AP1 to AP3 may be formed on the third side 200a of the active regions AR1 to AR3. In some embodiments, each of the active patterns AP1 to AP3 may include a fin-type pattern that protrudes from the third side 200a and extends long in the second direction Y. For example, the active patterns AP1 to AP3 may include a plurality of first active patterns AP1, a plurality of second active patterns AP2, and a plurality of third active patterns AP3. The first active patterns AP1 may protrude from the third side 200a of the first active region AR1 and extend long in the second direction Y. The second active patterns AP2 may protrude from the third side 200a of the second active region AR2 and extend long in the second direction Y. The third active patterns AP3 may protrude from the third side 200a of the third active region AR3 and extend long in the second direction Y.

Each of the active patterns AP1 to AP3 may include silicon (Si) or germanium (Ge) which is an elemental semiconductor material. Alternatively, each of the active patterns AP1 to AP3 may include a compound semiconductor, for example, a group IV-IV compound semiconductor or a group III-V compound semiconductor. The group IV-IV compound semiconductor may include, for example, a binary compound or a ternary compound including at least two or more of carbon (C), silicon (Si), germanium (Ge) and tin (Sn), or a compound obtained by doping these elements with a group IV element. The group III-V compound semiconductor may be, for example, at least one of a binary compound, a ternary compound or a quaternary compound formed by combining at least one of aluminum (Al), gallium (Ga) and indium (In) as a group III element with one of phosphorus (P), arsenic (As) and antimony (Sb) as a group V element. In the following description, each of the active patterns AP1 to AP3 is exemplified as a silicon (Si) pattern.

The field insulation film SI may be formed on the third side 200a of the active regions AR1 to AR3. The field insulation film SI may define a plurality of active patterns AP1 to AP3 on the active regions AR1 to AR3. For example, a field trench SIt that defines the plurality of active patterns AP1 to AP3 may be formed on the active regions AR1 to AR3. The field insulation film SI may fill at least a part of the field trench SIt. The field insulation film SI may surround side faces of each of the active patterns AP1 to AP3. The active patterns AP1 to AP3 may be separated from each other by the field insulation film SI.

In some embodiments, the field insulation film SI may cover some of side faces of each of the active patterns AP1 to AP3. For example, as shown in FIG. 5, some of each of the active patterns AP1 to AP3 may protrude below a surface S1 (e.g., a lower side) of the field insulation film SI.

The field insulation film SI may include, for example, but is not limited to, at least one of silicon nitride, silicon oxynitride, silicon oxycarbide, silicon boron nitride, silicon boron carbonitride, silicon oxycarbonitride and/or a combination thereof.

Although an interface between the first insulation pattern DI1 and the field insulation film SI is shown to exist, this is merely an example. It goes without saying that an interface between the first insulation pattern DI1 and the field insulation film SI may not exist in some cases.

In some embodiments, the surface S1 of the field insulation film SI and the surface S2 of the first insulation pattern DI1 may be disposed to be coplanar with each other. For example, as shown in FIG. 5, the lower side of the field insulation film SI and the lower side of the first insulation pattern DI1 may be disposed to be coplanar with each other.

A depth DT2 at which the first insulation pattern DI1 is formed in the first direction Z on the basis of the surface S2 of the first insulation pattern DI1 may be greater than a depth DT1 at which the field insulation film SI is formed on the basis of the surface S1 of the field insulation film SI. For example, as shown in FIG. 5, the upper side of the first insulation pattern DI1 may be formed to be higher than the upper side of the field insulation film SI. The upper side of the first insulation pattern DI1 may be closer to the fourth side 200b than the upper side of the field insulation film SI.

In some embodiments, the surface S2 of the first insulation pattern DI1 and the surface S3 of the second insulation pattern DI2 may be disposed to be coplanar with each other. For example, as shown in FIG. 5, the lowermost surface of the first insulation pattern DI1 and the lowermost surface of the second insulation pattern DI2 may be disposed to be coplanar with each other.

A depth DT3 at which the second insulation pattern DI2 is formed in the first direction Z on the basis of the surface S3 of the second insulation pattern DI2 may be greater than the depth DT2 at which the first insulation pattern DI1 is formed in the first direction Z on the basis of the surface S2 of the first insulation pattern DI1. For example, as shown in FIG. 5, the upper side of the first insulation pattern DI1 may be spaced from the fourth side 200b, and the upper side of the second insulation pattern DI2 may be disposed to be coplanar with the fourth side 200b.

The gate structures GS may be formed on the active patterns AP1 to AP3 and the field insulation film SI. The gate structures GS may intersect the active patterns AP1 to AP3. For example, each gate structure GS may extend long in the third direction X. The plurality of gate structures GS are spaced apart from each other and may extend side by side.

Each gate structure GS may include a gate dielectric film 120, a gate electrode 130, and a gate capping film 150. The gate dielectric film 120, the gate electrode 130, and the gate capping film 150 may be sequentially stacked on the active patterns AP1 to AP3.

The gate electrode 130 may include a conductive material, for example, but is not limited to, at least one of Ti, Ta, W, Al, Co, and/or a combination thereof. The gate electrode 130 may include, for example, silicon or silicon germanium, other than a metal.

Although the gate electrode 130 is shown as being a single film, this is merely an example. Unlike the shown example, the gate electrode 130 may be formed by stacking a plurality of conductive material layers. For example, the gate electrode 130 may include a work function adjustment film that adjusts the work function, and a filling conductive film that fills the space formed by the work function adjustment film. The work function control film may include, for example, at least one of TiN, TaN, TiC, TaC, TiAlC, and a combination thereof. The filling conductive film may include, for example, W or Al. Such a gate electrode 130 may be formed, for example, but is not limited to, by a replacement process.

The gate dielectric film 120 may be interposed between each of the active patterns AP1 to AP3 and the gate electrode 130. For example, the gate dielectric film 120 may extend conformally along the profile of each of the active patterns AP1 to AP3 protruding from the field insulation film SI. In some embodiments, a part of the gate dielectric film 120 may further extend along between the field insulation film SI and the gate electrode 130, and between the first insulation pattern DI1 and the gate electrode 130. For example, as shown in FIG. 5, the gate dielectric film 120 may further extend along the surface S1 of the field insulation film SI and the surface S2 of the first insulation pattern DI1.

The gate dielectric film 120 may include at least one of a dielectric material, for example, silicon oxide, silicon oxynitride, or silicon nitride, and a high-k material having a higher dielectric constant than that of silicon oxide. The high-k material may include, for example, but is not limited to, at least one of hafnium oxide, hafnium silicon oxide, hafnium aluminum oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, lead zinc niobate and/or combinations thereof.

The gate capping film 150 may extend along the lower side of the gate electrode 130. The gate capping film 150 may include an insulating material, for example, but is not limited to, at least one of silicon oxide, silicon nitride, silicon oxynitride, silicon oxycarbide, silicon boron nitride, silicon boron carbonitride, silicon oxycarbonitride and/or a combination thereof.

The spacer 140 may be formed on the first region I and the second region II. In some embodiments, the spacer 140 may include a first spacer film 142 and a second spacer film 144 that are stacked in sequence. Each of the first spacer film 142 and the second spacer film 144 may include at least one of an insulating material, for example, but are not limited to, silicon oxide, silicon nitride, silicon oxynitride, silicon oxycarbide, silicon boron nitride, silicon boron carbonitride, silicon oxycarbonitride and/or a combination thereof. Although an interface between the first spacer film 142 and the second spacer film 144 is shown to exist, this is merely an example. It goes without saying that there may be no interface between the first spacer film 142 and the second spacer film 144 in some cases.

The thickness of the spacer 140 on the first region I may be equal to the thickness of the spacer 140 on the second region II. For example, the thickness (e.g., T1a or T1b) of the first spacer film 142 on the first region I may be equal to the thickness (e.g., T1c) of the first spacer film 142 on the second region II. For example, the thickness (e.g., T2a or T2b) of the second spacer film 144 on the second region II may be equal to the thickness (e.g., T2c) of the second spacer film 144 on the second region II.

In some embodiments, the spacer 140 on the first region I may include a first spacer portion 140A, a second spacer portion 140B, a third spacer portion 140C, and a fourth spacer portion 140D.

The first spacer portion 140A may extend along the side faces of each active pattern AP1 to AP3 protruding from the field insulation film SI. The second spacer portion 140B may extend along the surface S1 of the field insulation film SI and/or the surface S2 of the first insulation pattern DI1 between the first active pattern AP1 and the second active pattern AP2. In some embodiments, as shown in the region R2a of FIG. 5, the second spacer portion 140B may extend along a part of the surface S2 of the first insulation pattern between the first active region AR1 and the second active region AR2.

The second spacer portion 140B may be spaced apart from the first spacer portion 140A on the first active region AR1. For example, the first spacer film 142 on the side face of the first active pattern AP1 and the first spacer film 142 of the second spacer portion 140B may be spaced apart from each other in the third direction X. In addition, the second spacer film 144 on the side face of the first active pattern AP1 and the second spacer film 144 of the second spacer portion 140B may be spaced apart from each other in the third direction X.

The second spacer portion 140B may be connected to the first spacer portion 140A on the second active region AR2. For example, the second spacer film 144 may extend continuously from the side face of the second active pattern AP2 along the surface S1 of the field insulation film SI and the surface S2 of the first insulation pattern.

In some embodiments, the second spacer portion 140B may have a step on the surface S2 of the first insulation pattern. For example, the first spacer film 142 on the side face of the second active pattern AP2 and the first spacer film 142 of the second spacer portion 140B may be spaced apart from each other in the third direction X. Therefore, a thickness (e.g., T1a+T2a) of the second spacer portion 140B including both the first spacer film 142 and the second spacer film 144 may be greater than a thickness (e.g., T2a) of the second spacer portion 140B including only the second spacer film 144.

The third spacer portion 140C may extend along the side face of each gate structure GS. The fourth spacer portion 140D may extend along the surface S1 of the field insulation film SI and/or the surface S2 of the first insulation pattern between the first active pattern AP1 and the third active pattern AP3. In some embodiments, as shown in the region R2b of FIG. 5, the fourth spacer portion 140D may extend along a part of the surface S2 of the first insulation pattern between the first active region AR1 and the third active region AR3.

The fourth spacer portion 140D may be spaced apart from the third spacer portion 140C on the first active region AR1. For example, the first spacer film 142 on the side face of the gate electrode 130 intersecting the first active pattern AP1, and the first spacer film 142 of the fourth spacer portion 140D may be spaced apart from each other in the second direction Y. Also, the second spacer film 144 on the side face of the gate electrode 130 intersecting the first active pattern AP1, and the second spacer film 144 of the fourth spacer portion 140D may be spaced apart from each other in the second direction Y.

The fourth spacer portion 140D may be connected to the third spacer portion 140C on the third active region AR3. For example, the second spacer film 144 may extend continuously from the surface of the gate electrode 130 intersecting the third active pattern AP3 along the surface S1 of the field insulation film SI and the surface S2 of the first insulation pattern.

In some embodiments, the fourth spacer portion 140D may have a step on the surface S2 of the first insulation pattern. For example, the first spacer film 142 on the side face of the gate electrode 130 intersecting the third active pattern AP3, and the first spacer film 142 of the fourth spacer portion 140D may be spaced apart from each other in the second direction Y. Thus, the thickness (e.g., T1b+T2b) of the fourth spacer portion 140D including both the first spacer film 142 and the second spacer film 144 may be greater than the thickness (e.g., T2b) of the fourth spacer portion 140D including only the second spacer film 144.

The spacer 140 on the second region II may include a fifth spacer portion 140E. The fifth spacer portion 140E may cover the second region II of the second substrate 200. For example, the fifth spacer portion 140E may extend along a profile of the second substrate 200 protruding from the surface S3 of the second insulation pattern DI2.

In some embodiments, the fifth spacer portion 140E may further extend along at least a part of the surface S3 of the second insulation pattern DI2. For example, as shown in the region R2c of FIG. 5, the fifth spacer portion 140E may extend continuously from the side face of the second substrate 200 along the surface S3 of the second insulation pattern.

In some embodiments, the fifth spacer portion 140E may have a step on the surface S3 of the second insulation pattern DI2. For example, a length DS1 of the first spacer film 142 extending along the surface S3 of the second insulation pattern DI2 may be different from a length DS2 of the second spacer film 144 extending along the surface S3 of the second insulation pattern DI2. As an example, the length DS1 of the first spacer film 142 extending along the surface S3 of the second insulation pattern DI2 may be smaller than the length DS2 of the second spacer film 144 extending along the surface S3 of the second insulation pattern DI2. Therefore, a thickness (e.g., T1c+T2c) of the fifth spacer portion 140E including both the first spacer film 142 and the second spacer film 144 may be greater than a thickness (e.g., T2c) of the fifth spacer portion 140E including only the second spacer film 144.

The source/drain patterns SD1 to SD3 may be formed on the active patterns AP1 to AP3. The source/drain patterns SD1 to SD3 may be connected to the active patterns AP1 to AP3 on the side faces of the gate structures GS. For example, the source/drain patterns SD1 to SD3 may include a first source/drain pattern SD1, a second source/drain pattern SD2, and a third source/drain pattern SD3. The first source/drain pattern SD1 may be connected to the first active pattern AP1 between the gate structures GS. The second source/drain pattern SD2 may be connected to the second active pattern AP2. The third source/drain pattern SD3 may be connected to the third active pattern AP3.

In some embodiments, the source/drain patterns SD1 to SD3 may include epitaxial layers that are grown by an epitaxial growth process from the active patterns AP1 to AP3. For example, each of the first source/drain pattern SD1, the second source/drain pattern SD2, and the third source/drain pattern SD3 may include an epitaxial pattern that is grown from the first active pattern AP1, the second active pattern AP2, and the third active pattern AP3.

When the first active region AR1 is an NFET region, the first source/drain pattern SD1 may include n-type impurities or impurities for preventing diffusion of n-type impurities. For example, the first source/drain pattern SD1 may include at least one of phosphorus (P), antimony (Sb), arsenic (As), and/or combinations thereof.

When each of the second active region AR2 and the third active region AR3 is a PFET region, each of the second source/drain pattern SD2 and the third source/drain pattern SD3 may include p-type impurities or impurities for preventing the diffusion of the p-type impurities. For example, each of the second source/drain pattern SD2 and the third source/drain pattern SD3 may include at least one of boron (B), indium (In), gallium (Ga), aluminum (Al) and/or combinations thereof.

A first etch stop film 160 may be formed on the first region I and the second region II. A thickness (e.g., T3a or T3b) of the first etch stop film 160 on the first region I may be equal to a thickness (e.g., T3c) of the first etch stop film 160 on the second region II.

The first etch stop film 160 on the first region I may be formed on the field insulation film SI, the first insulation pattern DI1, the spacer 140, and the source/drain patterns SD1 to SD3. For example, the first etch stop film 160 on the first region I may extend conformally along the profiles of the field insulation film SI, the first insulation pattern DI1, the spacer 140, and the source/drain patterns SD1 to SD3.

The first etch stop film 160 on the second region II may be formed on the second insulation pattern DI2 and the spacer 140. For example, the first etch stop film 160 on the second region II may extend conformally along the profiles of the second insulation pattern DI2 and the spacer 140.

The first etch stop film 160 may include an insulating material, for example, but is not limited to, silicon oxide, silicon nitride, silicon oxynitride, silicon oxycarbide, silicon boron nitride, silicon boron carbonitride, silicon oxycarbonitride and/or a combination thereof. As an example, the first etch stop film 160 may include a silicon nitride film.

In some embodiments, the first etch stop film 160 may be in contact with the first source/drain pattern SD1. For example, the spacer 140 may not extend along the first source/drain pattern SD1.

In some embodiments, the second spacer film 144 may further extend along the second source/drain pattern SD2 and the third source/drain pattern SD3. For example, as shown in a region R2a of FIG. 5, a part of the second spacer film 144 may be interposed between the second source/drain pattern SD2 and the first etch stop film 160. For example, as shown in a region R2b of FIG. 5, a part of the second spacer film 144 may be interposed between the third source/drain pattern SD3 and the first etch stop film 160.

A first interlayer insulation film 181 may be stacked on the first etch stop film 160. The first interlayer insulation film 181 may be formed to fill the space on the side face of the gate structure GS. The first interlayer insulation film 181 may include, for example, but is not limited to, at least one of silicon oxide, silicon oxynitride, and a low-k material having a dielectric constant smaller than that of silicon oxide. As an example, the first interlayer insulation film 181 may include a silicon oxide film.

A second etch stop film 182 may be stacked on the gate structures GS and the first interlayer insulation film 181. For example, the second etch stop film 182 may extend conformally along the profiles of the gate structures GS and the first interlayer insulation film 181. The second etch stop film 182 may include an insulating material, for example, but is not limited to, at least one of silicon oxide, silicon nitride, silicon oxynitride, silicon oxycarbide, silicon boron nitride, silicon boron carbonitride, silicon oxycarbonitride and/or a combination thereof. As an example, the first etch stop film 160 may include a silicon nitride film.

The second interlayer insulation film 183 may be stacked on the second etch stop film 182. The second interlayer insulation film 183 may include, for example, but is not limited to, at least one of silicon oxide, silicon oxynitride, and a low-k material having a dielectric constant smaller than that of silicon oxide. As an example, the second interlayer insulation film 183 may include a silicon oxide film.

The source/drain contact CA may be disposed on the side faces of the gate structures GS. The source/drain contact CA may be connected to the source/drain patterns SD1 to SD3. For example, the source/drain contact CA may penetrate the second interlayer insulation film 183, the second etch stop film 182, the first interlayer insulation film 181, and the first etch stop film 160, and come into contact with the first source/drain pattern SD1. For example, the source/drain contact CA may penetrate the second interlayer insulation film 183, the second etch stop film 182, the first interlayer insulation film 181, the first etch stop film 160, and the second spacer film 144, and come into contact with the second source/drain pattern SD3.

In some embodiments, the source/drain contact CA may include a barrier conductive film 270a and a filling conductive film 270b. The barrier conductive film 270a may include a metal or a metal nitride for preventing diffusion of the filling conductive film 270b. For example, the barrier conductive film 270a may include, but is not limited to, at least one of titanium (Ti), tantalum (Ta), tungsten (W), nickel (Ni), cobalt (Co), platinum (Pt), alloys thereof, and nitrides thereof. The filling conductive film 270b may fill the space that remains after the barrier conductive film 270a is formed. The filling conductive film 270b may include, for example, but is not limited to, at least one of aluminum (Al), copper (Cu), tungsten (W), molybdenum (Mo), cobalt (Co), and alloys thereof. In some embodiments, the filling conductive film 270b may include tungsten (W).

The through via TV may penetrate the second region II of the second substrate 200. Specifically, the through via TV may extend in the first direction Z and penetrate the second insulation pattern DI2. The through via TV may be spaced apart from the second region II of the second substrate 200 by the second insulation pattern DI2.

In some embodiments, the through via TV may further penetrate the first etch stop film 160, the first interlayer insulation film 181, the second etch stop film 182, and the second interlayer insulation film 183. In some embodiments, at least some of the second insulation pattern DI2, the first etch stop film 160, the first interlayer insulation film 181, the second etch stop film 182, and the second interlayer insulation film 183 may include a silicon oxide-based material. As an example, each of the second insulation pattern DI2, the first interlayer insulation film 181, and the second etch stop film 182 may include a silicon oxide film, and each of the first etch stop film 160 and the second etch stop film 182 may include a silicon oxide carbide film. In such a case, the etching process for forming the through via TV may be more easily performed.

In some embodiments, the through via TV may not penetrate the spacer 140. For example, as shown in a region R2c of FIG. 5, the spacer 140 may be spaced apart from the through via TV. In such a case, the etching process for forming the through via TV may be performed more easily.

In some embodiments, the width of the through via TV may decrease as it goes away from the second wiring structure 270. This may be due to the fact that etching process for forming the through via TV is performed in a direction from the third side 200a to the fourth side 200b.

In some embodiments, the through via TV may include a barrier conductive film 270a and a fill conductive film 270b. In some embodiments, the through via TV may be formed at the same level as the source/drain contact CA. In some embodiments, the through via TV may be formed at a different level from the source/drain contact CA.

The second insulation structure 280 may be disposed on the third side 200a of the second substrate 200. The second insulation structure 280 may cover the transistor on the second substrate 200. Although the second insulation structure 280 is shown as a single film, this is only an example, and the second insulation structure 280 may be multi-insulation films including a plurality of insulation films. The second insulation structure 280 may include, for example, but is not limited to, at least one of silicon oxide, silicon oxynitride, and a low-k material having a dielectric constant lower than that of silicon oxide.

The second wiring structure 270 may be formed inside the second insulation structure 280. The second wiring structure 270 may provide an electrical path connected to a peripheral circuit (e.g., a transistor) on the second substrate 200. For example, the second wiring structure 270 may include second wiring patterns 272 having a multi-layer structure, and second via patterns 271 that interconnect the second wiring patterns 272 of different layers from each other. The number of layers, the number, the shape, the placement and the like of the second wiring structure 270 are merely an example and are not limited to those shown in the drawings.

The front inter-wiring insulation film 380 may be stacked on the second insulation structure 280 and the second wiring structure 270. Although the front inter-wiring insulation film 380 is shown as a single film, this is merely an example and the front inter-wiring insulation film 380 may be multi-insulation films including a plurality of insulation films. The front inter-wiring insulation film 380 may include, for example, but is not limited to, at least one of silicon oxide, silicon oxynitride, and a low-k material having a dielectric constant smaller than that of silicon oxide.

The front wiring structure 370 may be formed inside the front inter-wiring insulation film 380. The front wiring structure 370 may provide an electrical path connected to the second wiring structure 270. For example, the front wiring structure 370 may include front wiring patterns 372 having a multi-layer structure, and front via patterns 371 that interconnect the front wiring patterns 372 of different layers from each other. The number of layers, number, shape, placement, and the like of the front wiring structure 370 are merely an example and are not limited to those shown in the drawings.

In some embodiments, the third side 200a of the second substrate 200 may face the memory cell structure MC. The semiconductor memory device according to some embodiments may have a C2C (chip to chip) structure. The C2C structure means a structure in which a lower chip including a cell region CELL is fabricated on a first wafer, an upper chip including a peripheral circuit region C/P is fabricated on a second wafer different from the first wafer, and then the lower chip and the upper chip are connected to each other by a bonding method.

As an example, the bonding method refers to a method of bonding the first bonding metal 190 (and/or the first bonding insulation film 195) formed on the uppermost metal layer of the lower chip, and the second bonding metal 390 (and/or the second bonding insulation film 395) formed on the uppermost metal layer of the upper chip to each other. As an example, if the first bonding metal 190 and the second bonding metal 390 are made of copper (Cu), the bonding method may be a Cu-Cu bonding method. However, this is merely an example, and it goes without saying that the first bonding metal 190 and the second bonding metal 390 may be formed of various other metals such as aluminum (Al) or tungsten (W).

As the first bonding metal 190 and the second bonding metal 390 are bonded, the first wiring structure 170 may be electrically connected to the front wiring structure 370. Accordingly, the unit memory cells of the cell region CELL may be electrically connected to the peripheral circuits (e.g., transistors) of the peripheral circuit region C/P.

The first back insulation film 285 may be formed on the fourth side 200b of the second substrate 200. The first back insulation film 285 may include, for example, but is not limited to, at least one of silicon oxide, silicon oxynitride, and a low-k material having a dielectric constant smaller than that of silicon oxide.

In some embodiments, an input/output pad 510 may be formed on the first back insulation film 285. The through via TV may be connected to the input/output pad 510. For example, the through via TV may further penetrate the first back insulation film 285 and come into contact with the input/output pad 510. In some embodiments, the through via TV may connect the second wiring structure 270 to the input/output pad 510. Accordingly, the input/output pad 510 may be electrically connected to unit memory cells of the cell region CELL and/or peripheral circuits (e.g., a transistor) of the peripheral circuit region C/P.

Referring to FIGS. 1 to 4 and 6, in the semiconductor memory device according to example embodiments, each of the first insulation pattern DI1 and the second insulation pattern DI2 may be a multi-layer including different material layers from each other.

For example, each of the first insulation pattern DI1 and the second insulation pattern DI2 may include a liner film 102 and a filling insulation film 104 that are stacked in sequence. The liner film 102 may extend conformally along the profile of the first separation trench DI1t and the profile of the second separation trench DI2t. The filling insulation film 104 may fill the region of the first separation trench DIlt and the region of the second separation trench DI2t that remain after the liner film 102 is filled.

The liner film 102 may include, for example, but is not limited to, at least one of polysilicon, silicon oxide, silicon nitride, silicon oxynitride, silicon oxycarbide, silicon boron nitride, silicon boron carbonitride, silicon oxycarbonitride and/or a combination thereof.

The filling insulation film 104 may include, for example, but is not limited to, at least one of silicon oxide, silicon nitride, silicon oxynitride, silicon oxycarbide, silicon boron nitride, silicon boron carbonitride, silicon oxycarbonitride and/or a combination thereof.

The liner film 102 and the filling insulation film 104 may include different material layers from each other. As an example, the liner film 102 may include a polysilicon film, and the filling insulation film 104 may include a silicon oxide film. As another example, the liner film 102 may include a silicon nitride film, and the filling insulation film 104 may include a silicon oxide film.

A thickness (e.g., T4a or T4b) of the liner film 102 on the first region I may be equal to a thickness of the liner film 102 on the second region II. The liner film 102 of the first insulation pattern DI1 and the liner film 102 of the second insulation pattern DI2 may be formed at the same level. For example, the liner film 102 of the first insulation pattern DI1 and the liner film 102 of the second insulation pattern DI2 may have materially the same compositions.

The filling insulation film 104 of the first insulation pattern DI1 and the filling insulation film 104 of the second insulation pattern DI2 may be formed at the same level. For example, the filling insulation film 104 of the first insulation pattern DI1 and the filling insulation film 104 of the second insulation pattern DI2 may have materially the same compositions.

Referring to FIGS. 1 to 4 and 7, in the semiconductor memory device according to some embodiments, the length DS1 of the first spacer film 142 extending along the surface S3 of the second insulation pattern DI2 may be greater than the length DS2 of the second spacer film 144 extending along the surface S3 of the second insulation pattern DI2.

Accordingly, the fifth spacer portion 140E may have a step on the surface S3 of the second insulation pattern DI2. For example, the thickness (e.g., T1c+T2c) of the fifth spacer portion 140E including both the first spacer film 142 and the second spacer film 144 may be greater than the thickness (e.g., T1c) of the fifth spacer portion 140E including only the first spacer film 142.

Referring to FIGS. 1 to 4 and 8, in the semiconductor memory device according to some embodiments, the spacer 140 may completely cover the surface S3 of the second insulation pattern DI2.

The through via TV may penetrate the spacer 140. In some embodiments, the spacer 140 may include a silicon oxide-based material. As an example, the spacer 140 may include a silicon oxycarbide film. In such a case, an etching process for forming the through via TV may be performed more easily.

Referring to FIGS. 1 to 4, 9 and 10, in the semiconductor memory device according to some embodiments, the second insulation pattern DI2 may include a first insulation portion DI2a and a second insulation portion DI2b.

The first insulation portion DI2a and the second insulation portion DI2b may be arranged along the first direction Z. The first insulation portion DI2a may be closer to the third side 200a of the second substrate 200 than the second insulation portion DI2b, and the second insulation portion DI2b may be closer to the fourth side 200b of the second substrate 200 than the first insulation portion DI2a.

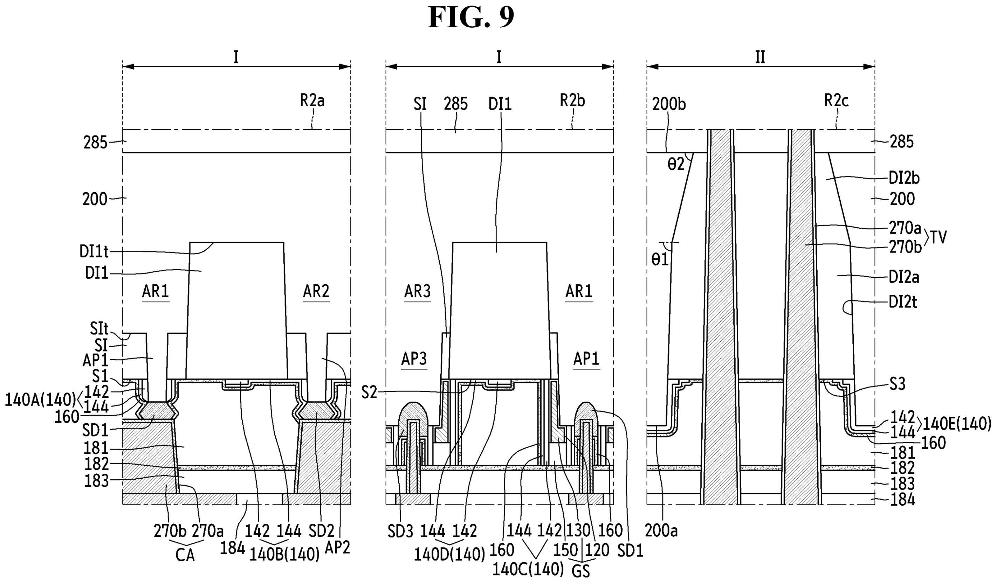

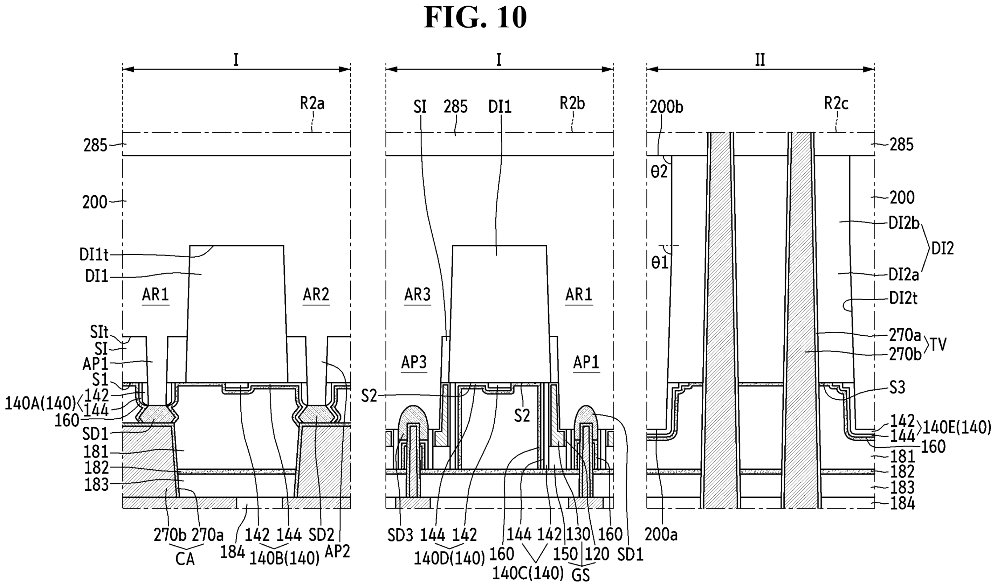

The side face of the first insulation portion DI2a and the side face of the second insulation portion DI2b may have different inclinations from each other. For example, a first outer angle θ1 formed by the fourth side 200b and the side face of the first insulation portion DI2a may be different from a second outer angle θ2 formed by the fourth side 200b and the side face of the second insulation portion DI2b. As an example, as shown in FIG. 9, the second outer angle θ2 may be smaller than the first outer angle θ1. As another example, as shown in FIG. 10, the second outer angle θ2 may be greater than the first outer angle θ1.

Referring to FIGS. 1 to 4 and 11, in the semiconductor memory device according to some embodiments, the second insulation pattern DI2 may be in contact with the third side 200a of the second region II.

For example, the surface S3 of the second insulation pattern DI2 may be disposed to be coplanar with the third side 200a of the second substrate 200. Each of the surface S1 of the field insulation film SI and the surface S2 of the first insulation pattern DI1 may be closer to the fourth side 200b of the second substrate 200 than the surface S3 of the second insulation pattern DI2.

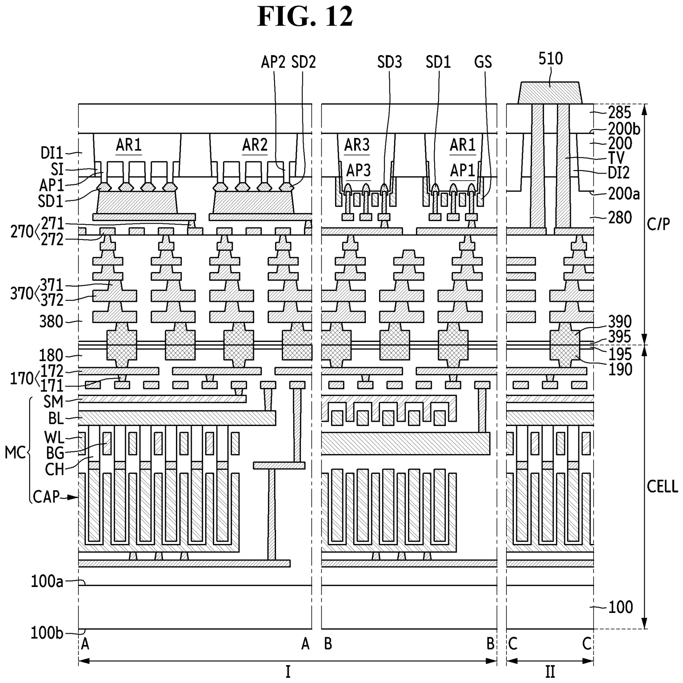

FIGS. 12 to 17 are various cross-sectional views for explaining a semiconductor memory device according to example embodiments. For convenience of explanation, repeated parts of contents explained above using FIGS. 1 to 11 will be briefly explained or omitted.

Referring to FIGS. 1 to 3 and 12, in the semiconductor memory device according to some embodiments, the active regions AR1 to AR3 may be completely separated.

For example, the upper side of the first insulation pattern DI1 may be disposed to be coplanar with the fourth side 200b of the second substrate 200, or may protrude above the fourth side 200b of the second substrate 200. As a result, the active regions AR1 to AR3 may be completely separated by the first insulation pattern DI1.

Referring to FIGS. 1 to 3 and 13, in the semiconductor memory device according to some embodiments, the active patterns AP1 to AP3 may be completely separated.

As described above with reference to FIGS. 3 and 4, when transistors having different conductivity types are disposed adjacent to each other, the transistors having different conductivity types may be coupled through a remaining region of the second substrate 200. As an example, for the first active region AR1 which is an NFET region, the first source/drain pattern SD1 which is an n-type and the first active region AR1 (or the first active pattern AP1) which is a p-type may be provided. In addition, for the second active region AR2 which is a PFET region, the second source/drain pattern SD2 which is a p-type and the second active region AR2 (or the second active pattern AP2) which is an n-type may be provided. In this case, the p-type first active region AR1 and the n-type second active region AR2 may be coupled through a region of the remaining second substrate 200 to form an NPNP junction structure. This may generate soft errors and/or noise in the peripheral circuit region C/P, thereby degrading the performance of the peripheral circuit region C/P.

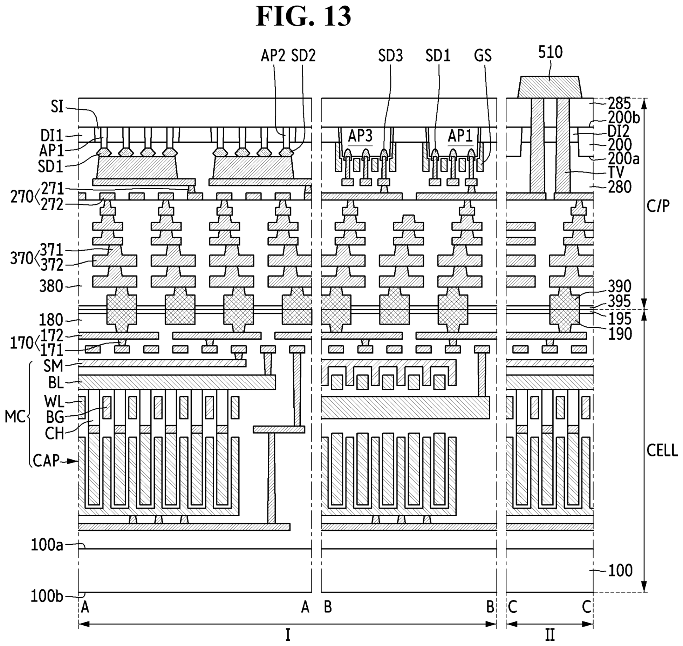

In contrast, as shown in FIGS. 12 and 13, when the active regions AR1 to AR3 and/or the active patterns AP1 to AP3 are completely separated from one another, the coupling between adjacent transistors having different conductivity types may be prevented. For example, as shown in FIG. 12, the p-type first active region AR1 and the n-type second active region AR2 may be separated from each other by the first insulation pattern DI1 and the first back insulation film 285. As another example, as shown in FIG. 13, the p-type first active pattern AP1 and the n-type second active pattern AP2 may be separated from each other by the field insulation film SI, the first insulation pattern DI1, and the first back insulation film 285. As a result, soft errors and/or noise may be prevented, thereby providing the peripheral circuit region C/P having improved performance.

For example, the upper side of the field insulation film SI may be disposed to be coplanar with the fourth side 200b of the second substrate 200, or may protrude above the fourth side 200b of the second substrate 200. Accordingly, the active patterns AP1 to AP3 may be completely separated by the field insulation film SI.

Referring to FIGS. 1 to 3 and 14, in the semiconductor memory device according to some embodiments, the peripheral circuit region C/P may further include a back wiring structure 470, a back inter-wiring insulation film 480, and a second back insulation film 485.

The back inter-wiring insulation film 480 may be stacked on the fourth side 200b of the second substrate 200. Although the back inter-wiring insulation film 480 is shown as being a single film, this is merely an example, and the back inter-wiring insulation film 480 may be a multi-insulation film including a plurality of insulation films. The back inter-wiring insulation film 480 may include, for example, but is not limited to, at least one of silicon oxide, silicon oxynitride, and a low-k material having a dielectric constant smaller than that of silicon oxide.

The back wiring structure 470 may be formed inside the back inter-wiring insulation film 480. The back wiring structure 470 may provide an electrical path connected to the second substrate 200 and/or the through via TV. For example, the back wiring structure 470 may include back wiring patterns 472 having a multi-layer structure, and back via patterns 471 that interconnect the back wiring patterns 472 of different layers from each other. The number of layers, the number, the shape, the placement, and the like of the back wiring structure 470 are merely an example and are not limited to those shown in the drawings.

The second back insulation film 485 may be stacked on the back inter-wiring insulation film 480. The second back insulation film 485 may include, for example, but is not limited to, at least one of silicon oxide, silicon oxynitride, and a low-k material having a lower dielectric constant than silicon oxide.

In some embodiments, an input/output pad 510 may be formed on the second back insulation film 485. The through via TV may be connected to the input/output pad 510. For example, a first via 475 which penetrates the second back insulation film 485 and connects the back wiring structure 470 and the input/output pad 510 may be formed.

Referring to FIGS. 1 to 3 and 15, in the semiconductor memory device according to some embodiments, the width of the through via TV may decrease toward the second wiring structure 270.

This may be due to the fact that the etching process for forming the through via TV is performed in a direction from the fourth side 200b toward the third side 200a. In some embodiments, the through via TV may include copper (Cu).

Referring to FIGS. 1 to 3, 16A to 16C, in the semiconductor memory device according to some embodiments, the fourth side 200b of the second substrate 200 may face the memory cell structure MC.

For example, the second substrate 200 may be stacked on the first wiring structure 170 and the first insulation structure 180.

In some embodiments, the width of the through via TV may decrease toward the first wiring structure 170. This may be due to the fact that etching process for forming the through via TV is performed in a direction from the third side 200a toward the fourth side 200b.

In some embodiments, a front insulation film 385 may be formed on the front wiring structure 370 and the front inter-wiring insulation film 380. The input/output pad 510 may be formed on the front insulation film 385. The through via TV may be connected to the input/output pad 510. For example, a second via 375 which penetrates the front insulation film 385 and connects the front wiring structure 370 and the input/output pad 510 may be formed.

Referring to FIGS. 1 to 3 and FIG. 16B, in the semiconductor memory device according to some embodiments, the active regions AR1 to AR3 may be completely separated.

For example, the lower side of the first insulation pattern DI1 may be coplanar with the fourth side 200b of the second substrate 200, or may protrude below the fourth side 200b of the second substrate 200. Accordingly, the active regions AR1 to AR3 may be completely separated from each other by the first insulation pattern DI1.

Referring to FIGS. 1 to 3 and FIG. 16C, in the semiconductor memory device according to some embodiments, the active patterns AP1 to AP3 may be completely separated.

For example, the lower side of the field insulation film SI may be coplanar with the fourth side 200b of the second substrate 200, or may protrude below the fourth side 200b of the second substrate 200. Accordingly, the active patterns AP1 to AP3 may be completely separated from each other by the field insulation film SI.

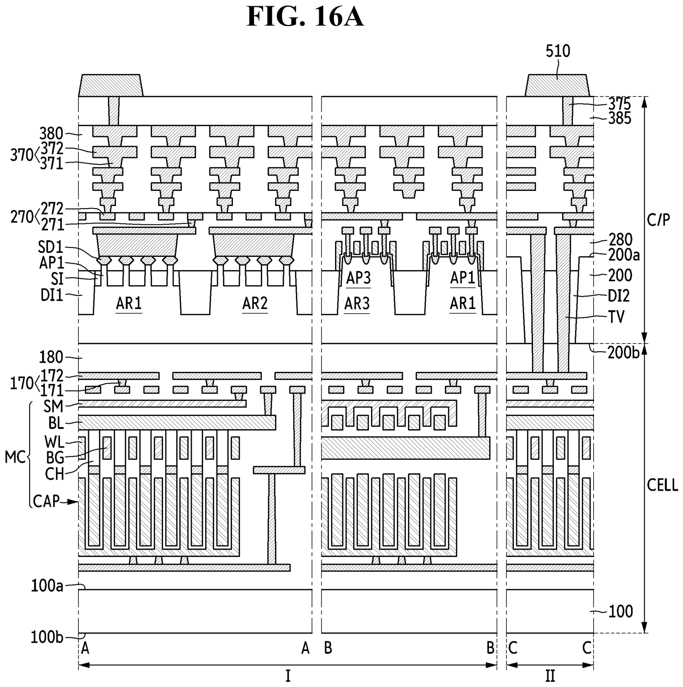

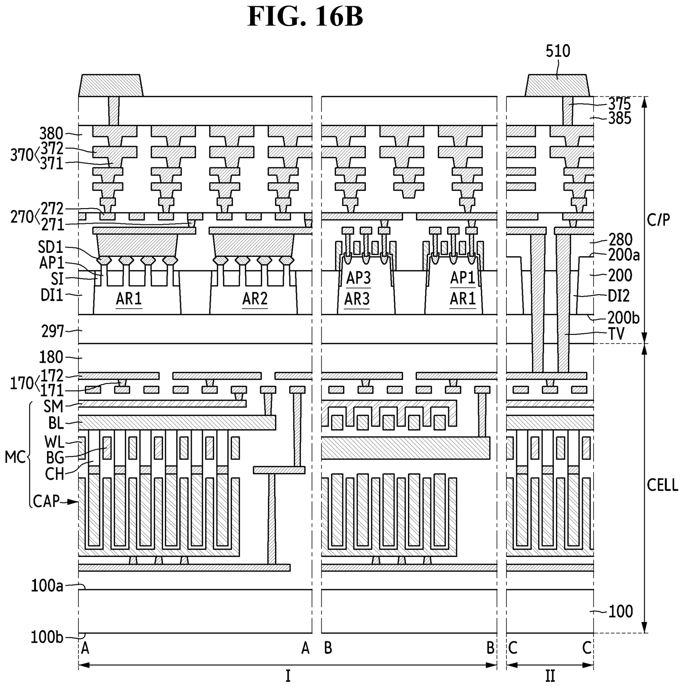

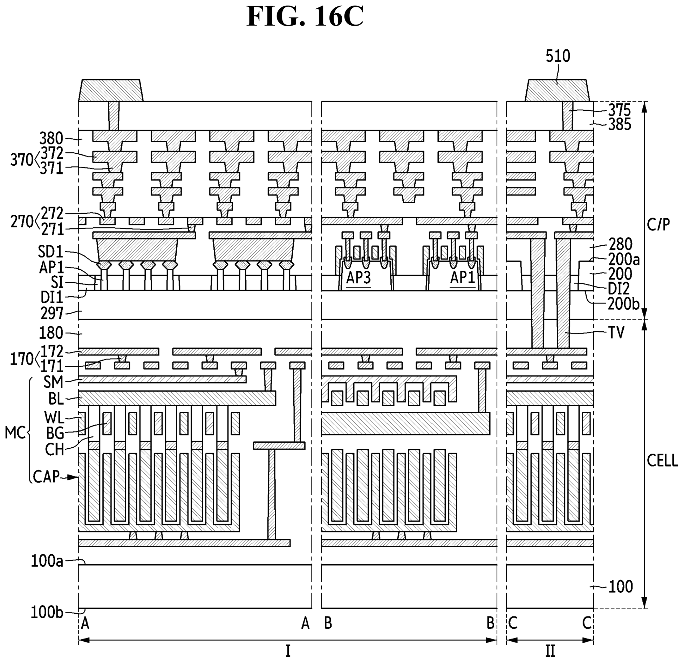

As shown in FIGS. 16B and 16C, in some embodiments, a bonding buffer film 297 may be formed between the cell region CELL and the second substrate 200. The peripheral circuit region C/P may be bonded onto the cell region CELL via the bonding buffer film 297. For example, the bonding buffer film 297 may be formed on an upper side of the first insulation structure 180, and the fourth side 200b of the second substrate 200 may be bonded onto an upper side of the bonding buffer film 297.

The bonding buffer film 297 may include an insulating material, for example, but is not limited to, at least one of silicon oxide, silicon nitride, silicon oxynitride, silicon oxycarbide, silicon boron nitride, silicon boron carbonitride, silicon oxycarbonitride and/or combination thereof.

As described above with reference to FIGS. 12 and 13, when the active regions AR1 to AR3 and/or the active patterns AP1 to AP3 are completely separated from each other, the coupling between adjacent transistors having different conductivity types may be prevented. As an example, as shown in FIG. 16B, the p-type first active region AR1 and the n-type second active region AR2 may be separated from each other by the first insulation pattern DI1 and the bonding buffer film 297. As another example, as shown in FIG. 16C, the p-type first active pattern AP1 and the n-type second active pattern AP2 may be separated from each other by the field insulation film SI, the first insulation pattern DI1, and the bonding buffer film 297. As a result, soft errors and/or noise may be prevented, thereby providing the peripheral circuit region C/P having improved performance.

Referring to FIGS. 1 to 3 and 17, in the semiconductor memory device according to some embodiments, the peripheral circuit region C/P includes a first peripheral circuit region C/P1 and a second peripheral circuit region C/P2 that are stacked along the first direction Z.

The first peripheral circuit region C/P1 and the second peripheral circuit region C/P2 may be sequentially stacked on the cell region CELL. Each of the first peripheral circuit region C/P1 and the second peripheral circuit region C/P2 may correspond to one of the peripheral circuit regions C/P described above using FIGS. 1 to 16C. For example, each of the first peripheral circuit region C/P1 and the second peripheral circuit region C/P2 may include a second substrate 200, a first insulation pattern DI1, a second insulation pattern DI2, a field insulating film SI, gate structures GS, source/drain patterns SD1 to SD3, a through via TV, a second insulation pattern DI2, and a second insulation structure 280.

In some embodiments, the first peripheral circuit region C/P1 may include at least one of the first core region CORE1 and the second core region CORE2. In some embodiments, the second peripheral circuit region C/P2 may include at least one of the first peri-region PERI1 and the second peri-region PERI2.

In some embodiments, the third side 200a of the first peripheral circuit region C/P1 and the third side 200a of the second peripheral circuit region C/P2 may face each other. For example, a bonding metal 290 (and/or a third bonding insulation film 295) formed on the uppermost metal layer of the first peripheral circuit region C/P 1 may be bonded to the third bonding metal 290 (and/or the third bonding insulation film 295) formed on the uppermost metal layer of the second peripheral circuit region C/P2. If the third bonding metal 290 is formed of copper (Cu), the bonding method may be a Cu-Cu bonding method. However, this is merely an example, and it goes without saying that the third bonding metal 290 may be formed of various other metals such as aluminum (Al) or tungsten (W).

Hereinafter, a method for fabricating a semiconductor memory device according to exemplary embodiments will be described referring to FIGS. 1 to 40.

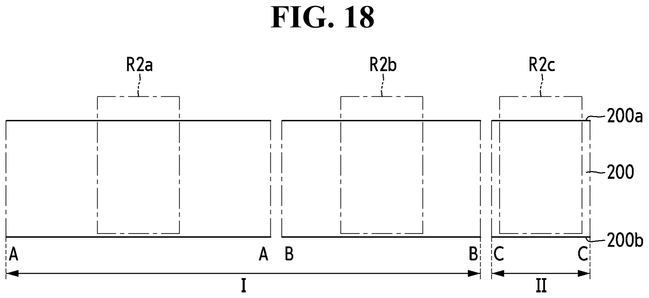

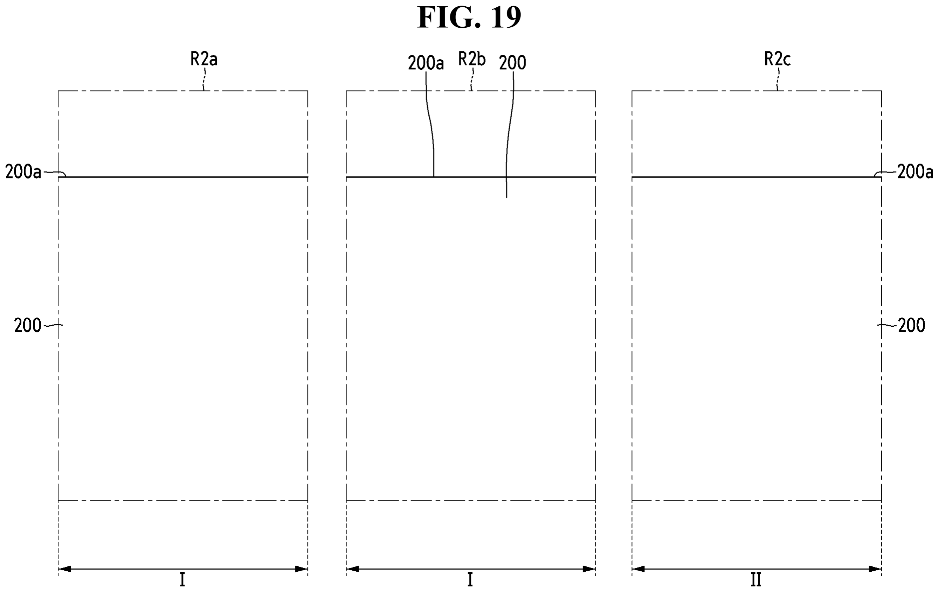

FIGS. 18 to 34 are intermediate step diagrams for describing the method for fabricating the semiconductor memory device according to example embodiments. For convenience of description, repeated parts of contents explained above using FIGS. 1 to 17 will be briefly described or omitted. For reference, FIG. 19 is an enlarged view for explaining regions R2a, R2b, and R2c of FIG. 18.

Referring to FIGS. 18 and 19, the second substrate 200 including the first region I and the second region II is provided.

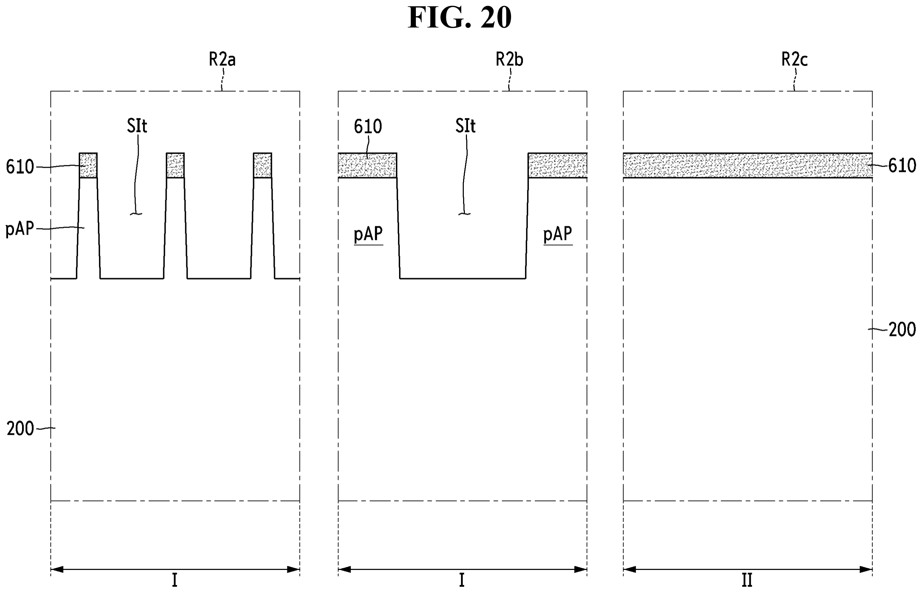

Referring to FIG. 20, a field trench SIt is formed inside the first region I of the second substrate 200.

For example, a first mask pattern 610 may be formed on the second substrate 200. Then, an etching process may be performed on the second substrate 200, using the first mask pattern 610 as an etching mask. As the etching process is performed, a field trench SIt that defines a plurality of preliminary active patterns pAP may be formed on the second substrate 200.

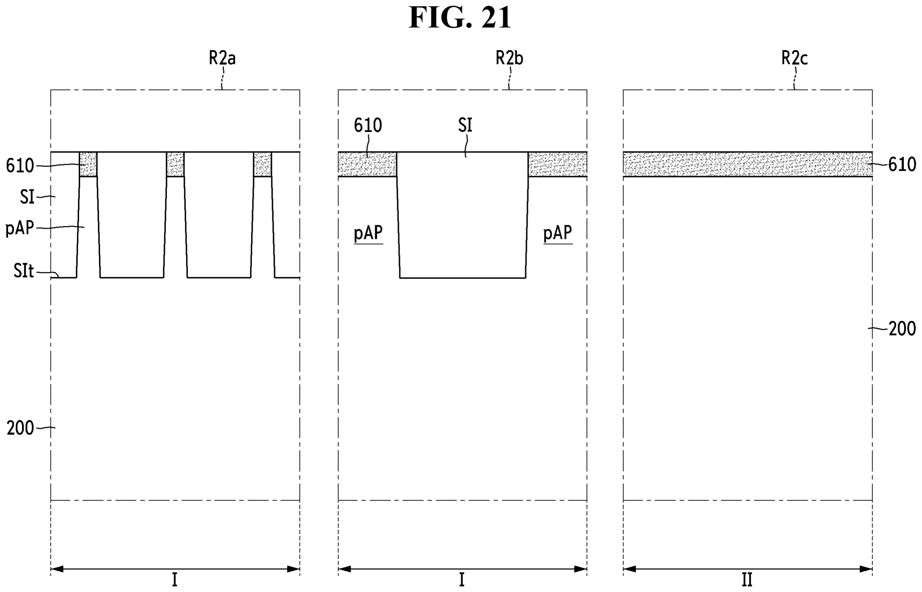

Referring to FIG. 21, the field insulation film SI is formed.

The field insulation film SI may fill at least a part of the field trench SIt. The field insulation film SI may surround side faces of each preliminary active pattern pAP. The preliminary active patterns pAP may be separated from each other by the field insulation film SI.

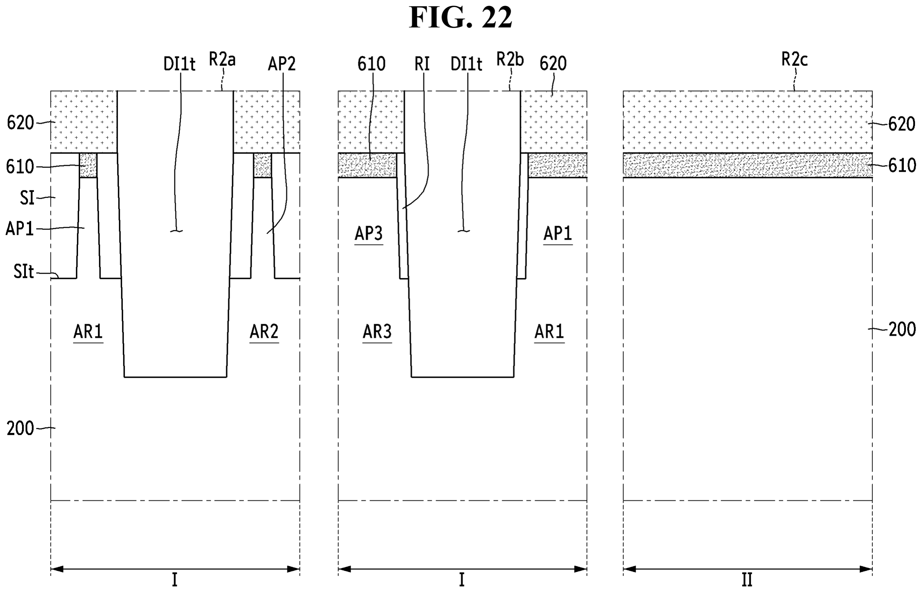

Referring to FIG. 22, a first separation trench DI1t is formed inside the field insulation film SI and the first region I of the second substrate 200.

For example, a second mask pattern 620 may be formed on the first mask pattern 610 and the field insulation film SI. Next, an etching process may be performed on the field insulation film SI and the second substrate 200, using the second mask pattern 620 as an etching mask. As the etching process is performed, the first separation trench DI1t that defines a plurality of active regions AR1 to AR3 may be formed inside the second substrate 200. In some embodiments, the etching process may remove some of the preliminary active patterns pAP of FIG. 21. Accordingly, the active patterns AP1 to AP3 may be formed from the preliminary active patterns pAP of FIG. 21.

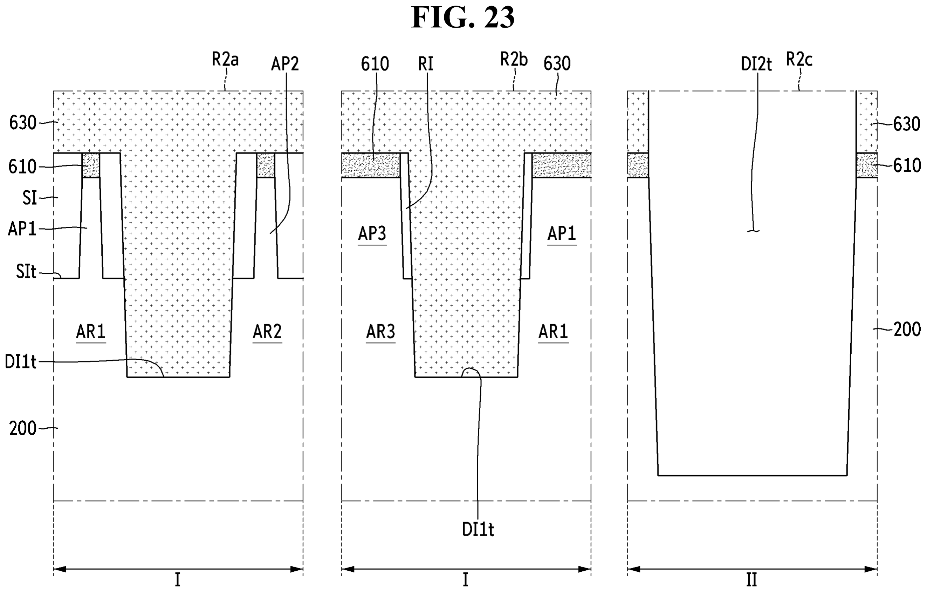

After the first separation trench DIlt is formed, the second mask pattern 620 may be removed. Referring to FIG. 23, a second separation trench DI2t is formed inside the second region II of the second substrate 200.

For example, a third mask pattern 630 may be formed on the second substrate 200, the first mask pattern 610, and the field insulation film SI. The third mask pattern 630 may fill the first separation trench DI1t. Next, an etching process may be performed on the second region II of the second substrate 200, using the third mask pattern 630 as an etching mask. As the etching process is performed, the second separation trench DI2t may be formed inside the second region II of the second substrate 200.

A depth at which the second separation trench DI2t is formed may be greater than a depth at which the first separation trench DI1t is formed. For example, the lower side of the second separation trench DI2t may be closer to the fourth side 200b of the second substrate 200 than the lower side of the first separation trench DI1t.

After the second separation trench DI2t is formed, the third mask pattern 630 may be removed.

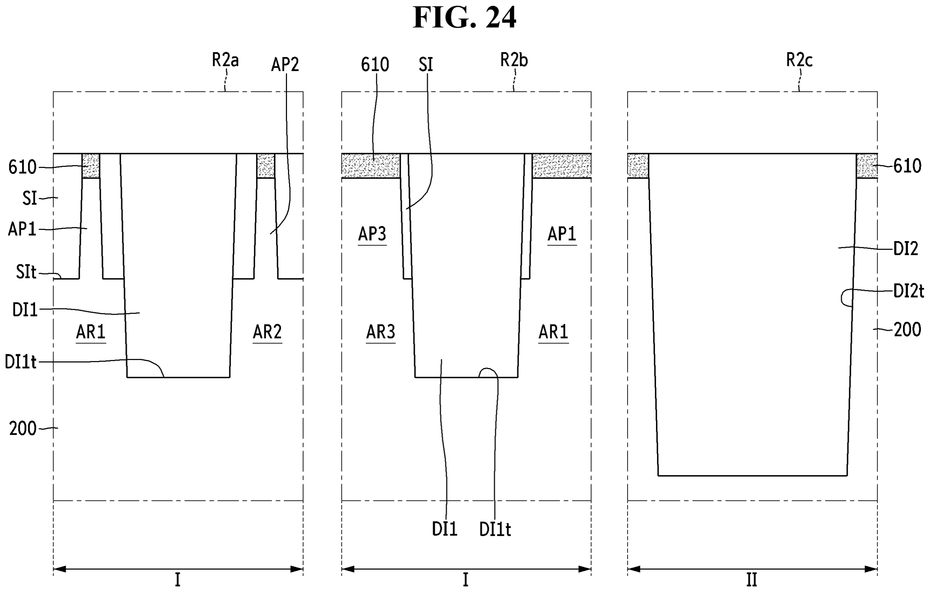

Referring to FIG. 24, the first insulation pattern DI1 and the second insulation pattern DI2 are formed.

The first insulation pattern DI1 may fill at least a part of the first separation trench DI1t. The second insulation pattern DI2 may fill at least a part of the second separation trench DI2t. The first insulation pattern DI1 and the second insulation pattern DI2 may be formed at the same level. For example, the first insulation pattern DI1 and the second insulation pattern DI2 may be formed simultaneously by the same deposition process.

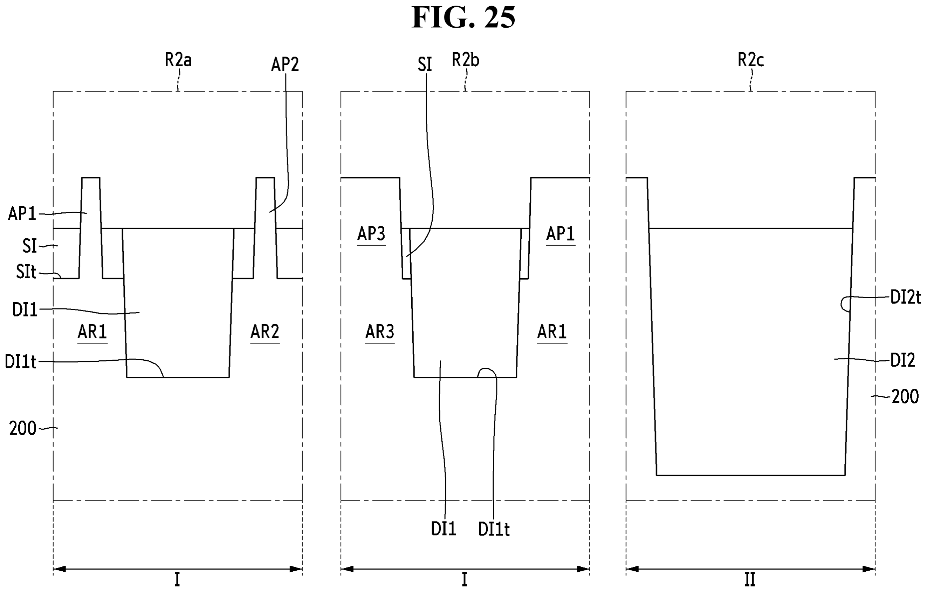

Referring to FIG. 25, a recess process is performed on the field insulation film SI, the first insulation pattern DI1, and the second insulation pattern DI2.

As the recess process is performed, the upper side of the field insulation film SI and the upper side of the first insulation pattern DI1 may become lower than the upper sides of the respective active patterns AP1 to AP3. Accordingly, some of each of the active patterns AP1 to AP3 may be exposed. Also, as the recess process is performed, the upper side of the second insulation pattern DI2 may become lower than the third side 200a of the second substrate 200.

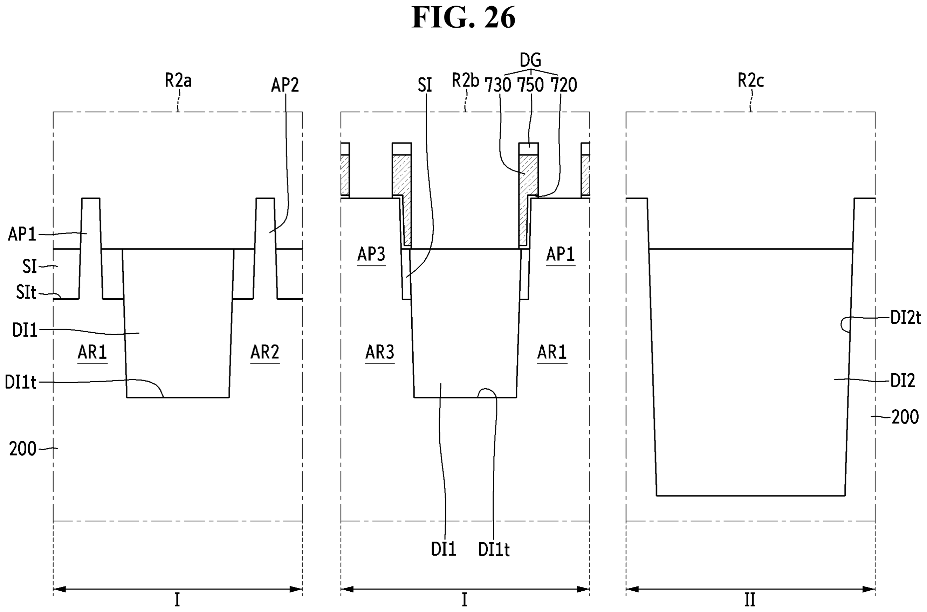

Referring to FIG. 26, dummy gate structures DG are formed on the first region I of the second substrate 200.

The dummy gate structures DG may be formed on the active patterns AP1 to AP3 and the field insulation film SI. The dummy gate structures DG may intersect the active patterns AP1 to AP3. The dummy gate structures DG are spaced apart from each other, and may extend side by side.

Each dummy gate structure DG may include a dummy gate dielectric film 720 and a dummy gate electrode 730. For example, a dielectric film and an electrode film stacked in sequence may be formed on the active patterns AP1 to AP3 and the field insulation film SI. Next, a gate mask pattern 750 extending long in the third direction X may be formed on the electrode film. Next, a patterning process for patterning the dielectric film and the electrode film may be performed, by using the gate mask pattern 750 as an etching mask. The patterned dielectric film may form the dummy gate dielectric film 720, and the electrode film may form the dummy gate electrode 730.

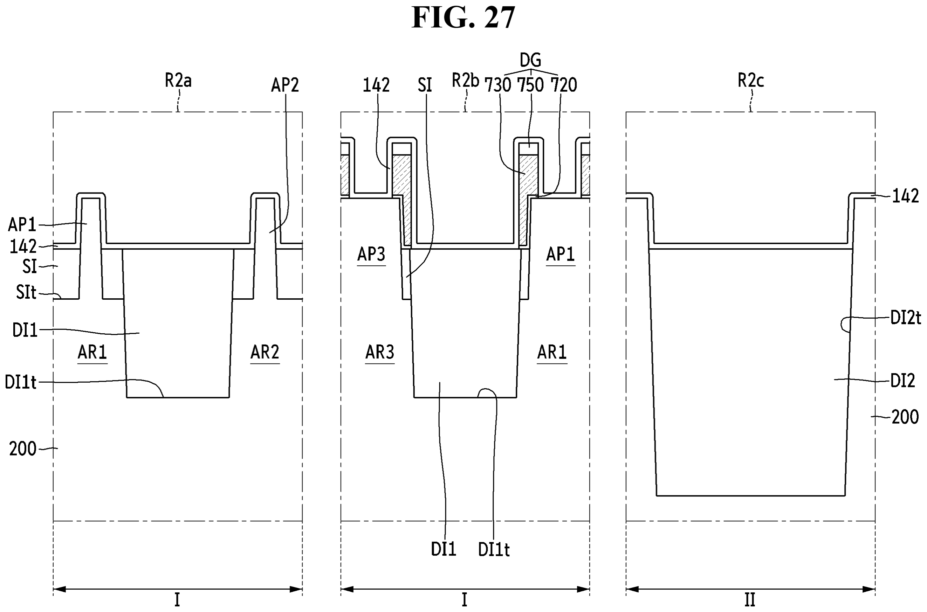

Referring to FIG. 27, a first spacer film 142 is formed.

The first spacer film 142 may be formed on the first region I and the second region II. The first spacer film 142 may extend conformally along the profile of the surface of the resulting product of FIG. 26.

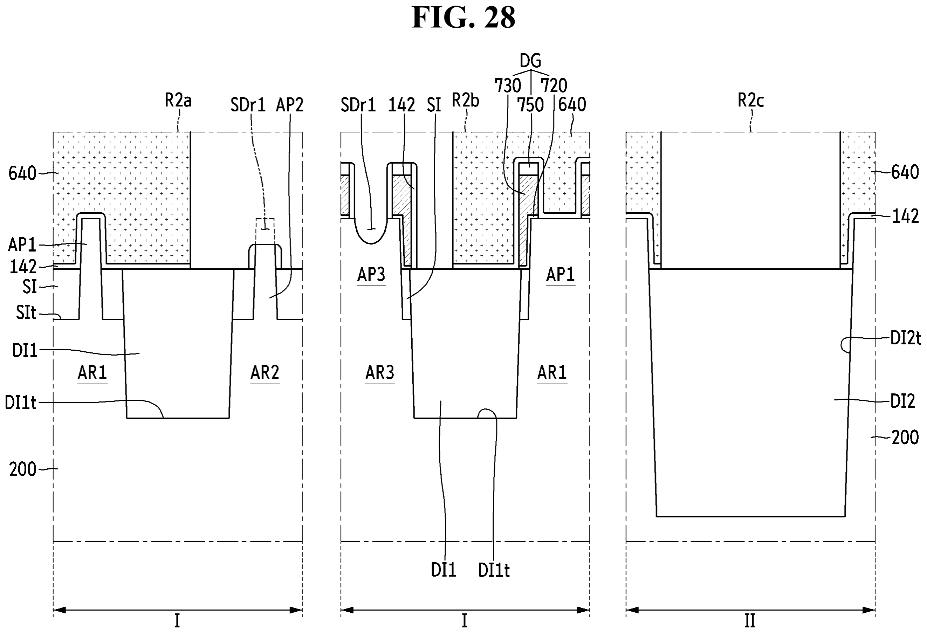

Referring to FIG. 28, a first source/drain recess SDr1 is formed inside the second active pattern AP2 and the third active pattern AP3.

For example, a fourth mask pattern 640 may be formed on the first spacer film 142. The fourth mask pattern 640 may cover the first spacer film 142 on the first active pattern AP1, and expose the first spacer film 142 on the second active pattern AP2 and the third active pattern AP3. The fourth mask pattern 640 may also cover the first spacer film 142 on the second region II of the second substrate 200. Next, a recess process may be performed on the first spacer film 142, the second active pattern AP2, and the third active pattern AP3, by using the fourth mask pattern 640 as an etching mask. As the recess process is performed, a first source/drain recess SDr1 may be formed inside the second active pattern AP2 on the side faces of the dummy gate structures DG and the third active pattern AP3 on the side faces of the dummy gate structures DG. For example, a portion of an upper side of the second active pattern AP2 and a portion of an upper side of the third active pattern AP3 may be lower than an uppermost side of the first active pattern AP1 by forming the first source/drain recess SDr1.

In some embodiments, a part of the first insulation pattern DI1 may be exposed by a recess process using the fourth mask pattern 640. For example, the fourth mask pattern 640 may cover only a part of the first insulation pattern DI1 between the first active region AR1 and the second active region AR2 and a part of the first insulation pattern DI1 between the first active region AR1 and the third active region AR3.

In some embodiments, at least a part of the second insulation pattern DI2 may be exposed by a recess process using the fourth mask pattern 640. For example, the fourth mask pattern 640 may not cover at least a part of the second insulation pattern DI2.

After the recess process is performed, the fourth mask pattern 640 may be removed.

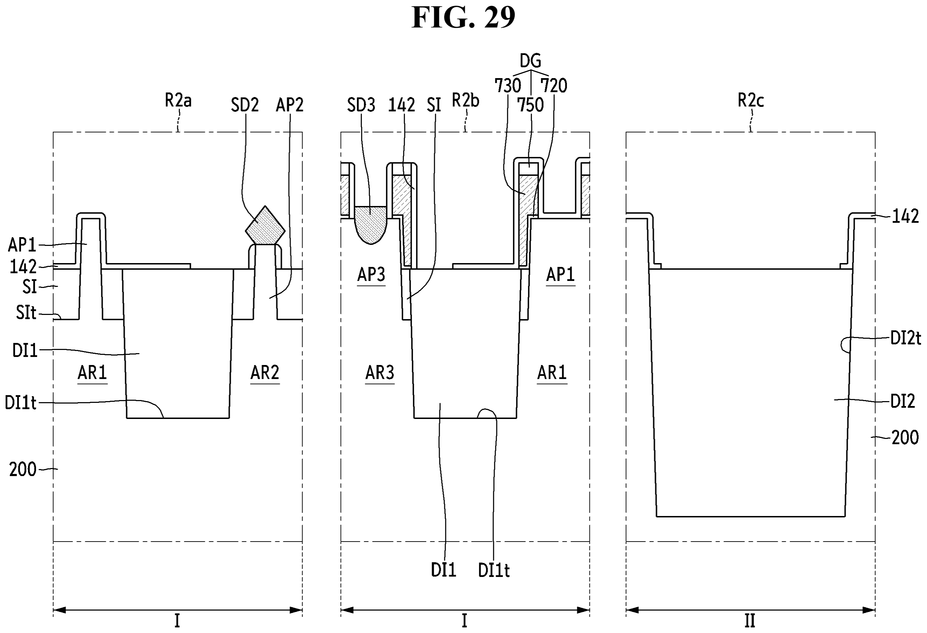

Referring to FIG. 29, a second source/drain pattern SD2 and a third source/drain pattern SD3 are formed.

For example, an epitaxial growth process of using the second active pattern AP2 and the third active pattern AP3 as seeds may be performed. Accordingly, the second source/drain pattern SD2 may be grown from the second active pattern AP2, and the third source/drain pattern SD3 may be grown from the third active pattern AP3.

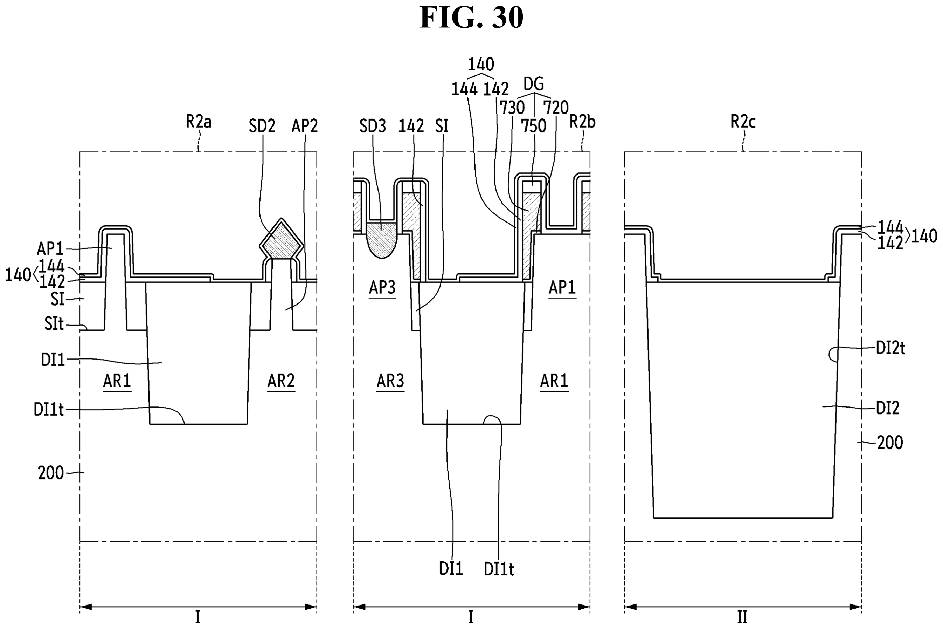

Referring to FIG. 30, a second spacer film 144 is formed.

The second spacer film 144 may be formed on the first region I and the second region II. The second spacer film 144 may extend conformally along the surface profile of the resulting product of FIG. 29.

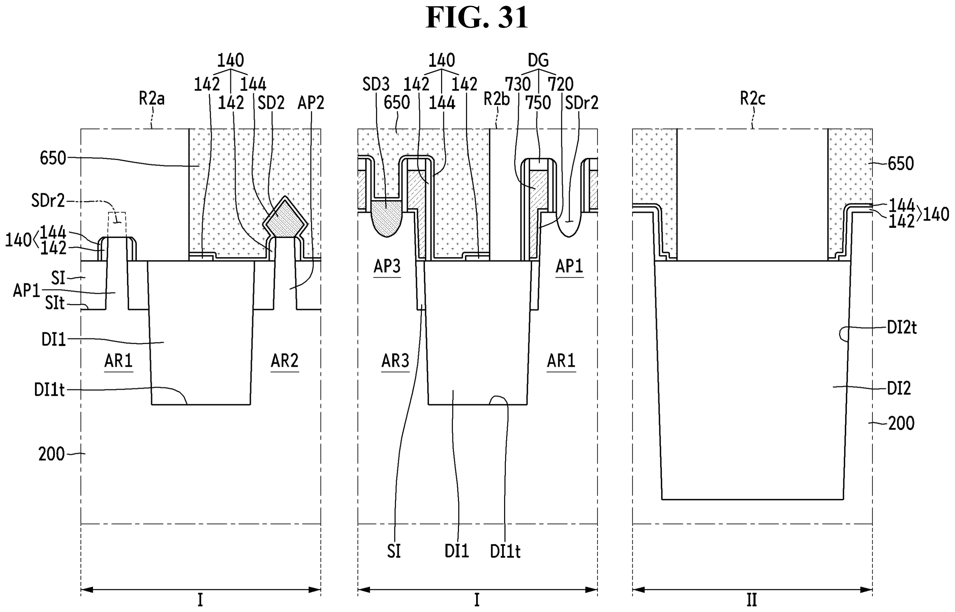

Referring to FIG. 31, a second source/drain recess SDr2 is formed inside the first active pattern AP1.

For example, a fifth mask pattern 650 may be formed on the second spacer film 144. The fifth mask pattern 650 may cover the second spacer film 144 on the second active pattern AP2 and the third active pattern AP3, and expose the second spacer film 144 on the first active pattern AP1. The fifth mask pattern 650 may also cover the second spacer film 144 on the second region II of the second substrate 200. Subsequently, a recess process may be performed on the second spacer film 144, the first spacer film 142, and the first active pattern AP1, by using the fifth mask pattern 650 as an etching mask. As the recess process is performed, a second source/drain recess SDr2 may be formed inside the first active pattern AP1 on the side faces of the dummy gate structures DG. For example, a portion of an upper side of the first active pattern AP1 may be lower than an uppermost surface of the second active pattern AP2 and an uppermost side of the third active pattern AP3 by forming the second source/drain recess SDr2.

In some embodiments, a part of the first insulation pattern DI1 may be exposed by the recess process using the fifth mask pattern 650. For example, the fifth mask pattern 650 may cover only a part of the first insulation pattern DI1 between the first active region AR1 and the second active region AR2, and a part of the first insulation pattern DI1 between the first active region AR1 and the third active region AR3.

In some embodiments, at least a part of the second insulation pattern DI2 may be exposed by a recess process using the fifth mask pattern 650. For example, the fifth mask pattern 650 may not cover at least a part of the second insulation pattern DI2.

After the recess process is performed, the fifth mask pattern 650 may be removed.

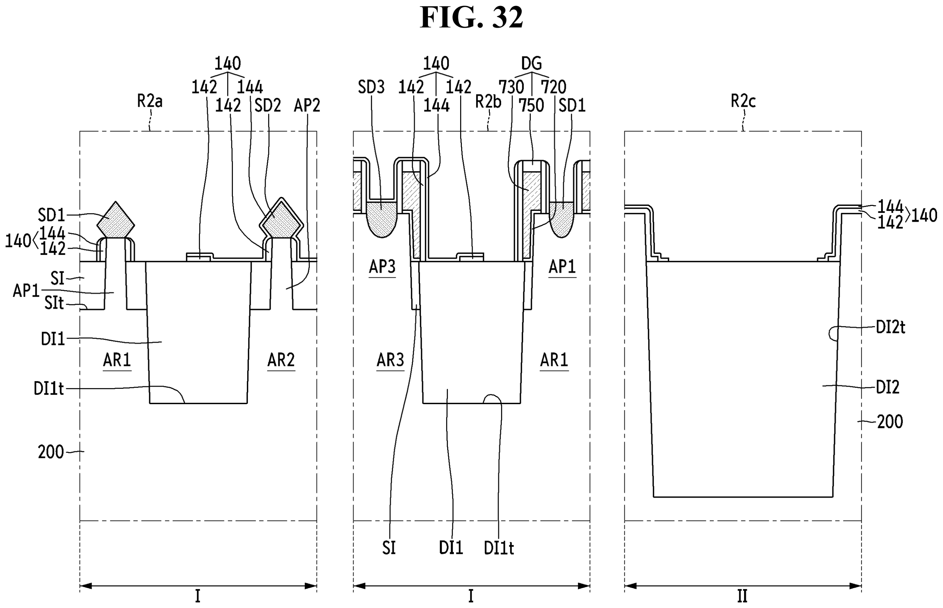

Referring to FIG. 32, the first source/drain pattern SD1 is formed.

For example, an epitaxial growth process of using the first active pattern AP1 as a seed may be performed. Accordingly, the first source/drain pattern SD1 may be grown from the first active pattern AP1.

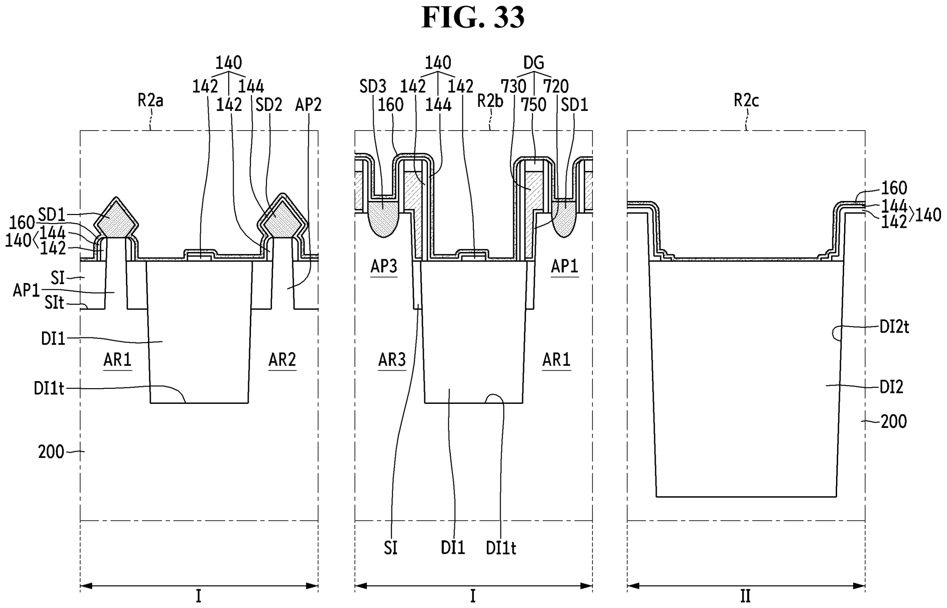

Referring to FIG. 33, the first etch stop film 160 is formed.

The first etch stop film 160 may be formed on the first region I and the second region II. The first etch stop film 160 may extend conformally along the profile of the surface of the resulting product of FIG. 32.

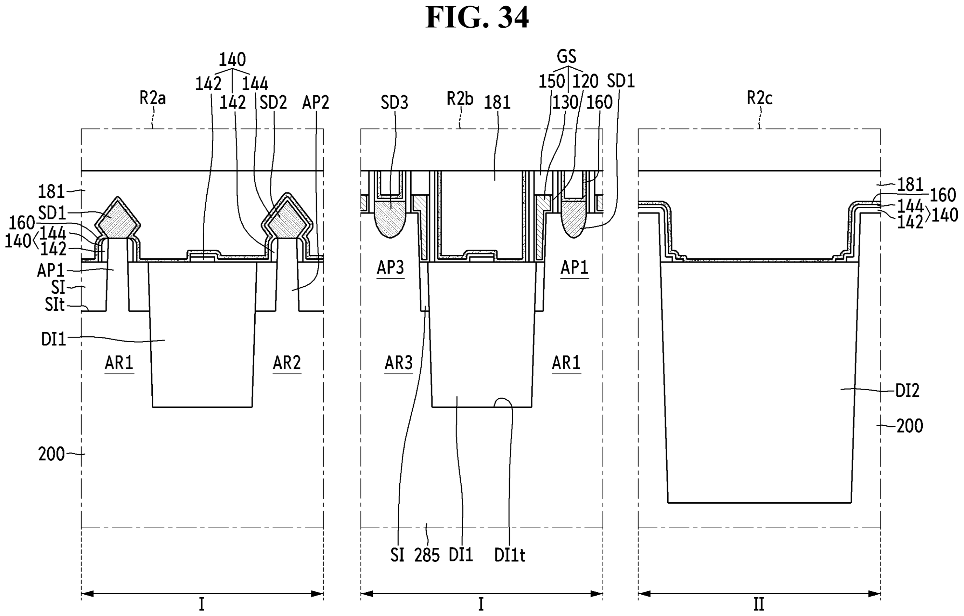

Referring to FIG. 34, gate structures GS are formed.

For example, a first interlayer insulation film 181 may be formed on the first etch stop film 160. Next, a gate dielectric film 120 and a gate electrode 130 that replace the dummy gate dielectric film 720 and the dummy gate electrode 730 may be formed.

Referring again to FIG. 5, the source/drain contact CA and the second wiring structure 270 may be formed. Next, a back grinding process may be performed on the fourth side 200b of the second substrate 200. As the back grinding process is performed, the second insulation pattern DI2 penetrating the second substrate 200 may be formed. Next, the through via TV penetrating the second insulation pattern DI2 may be formed. As a result, the semiconductor memory device described above using FIGS. 1 to 5 may be fabricated.

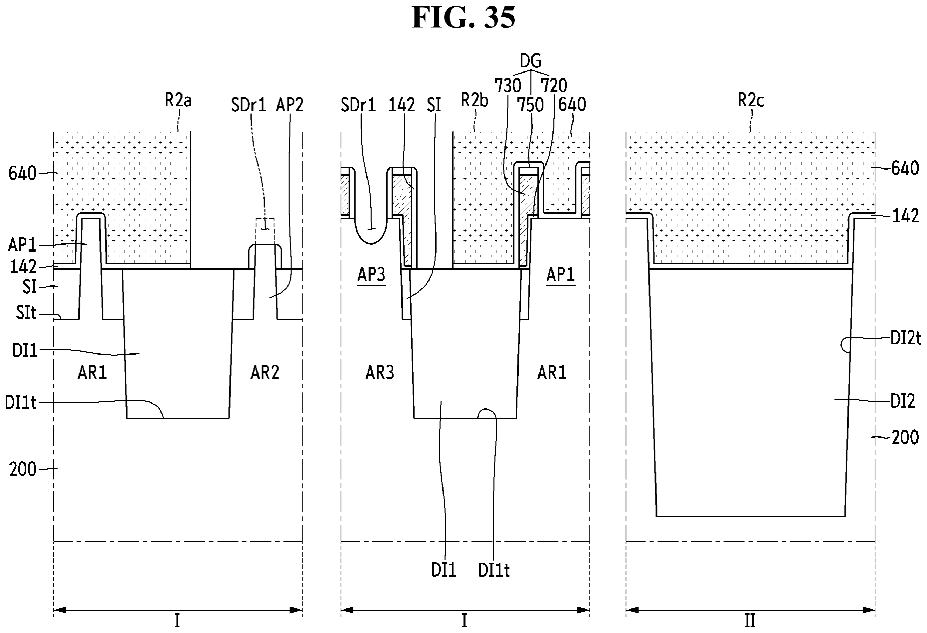

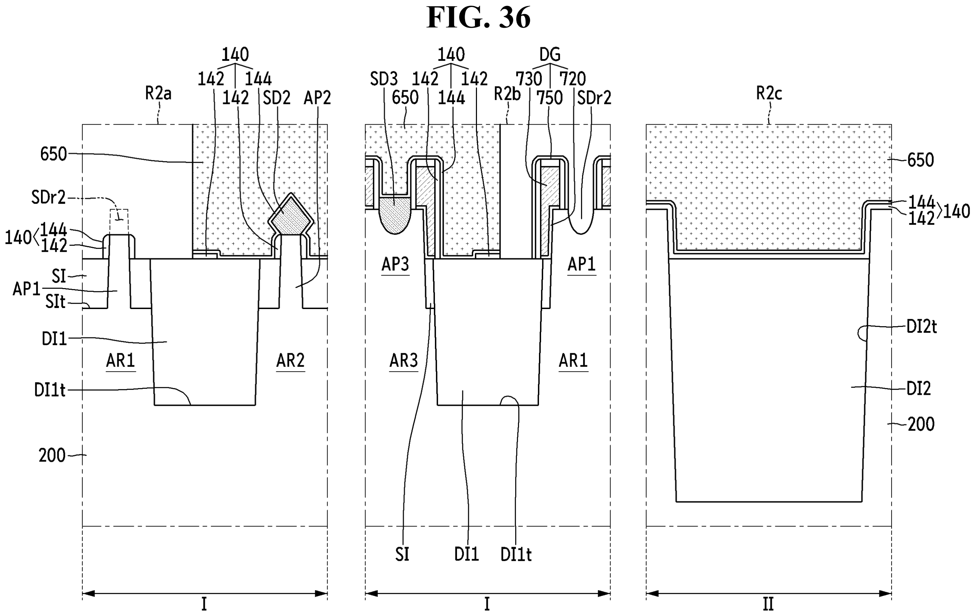

FIGS. 35 and 36 are intermediate step diagrams for explaining the method for fabricating a semiconductor memory device according to example embodiments. For reference, FIG. 35 is an intermediate step diagram for explaining the steps after FIG. 27. For convenience of explanation, repeated parts of contents explained above using FIGS. 1 to 34 will be briefly explained or omitted.

Referring to FIG. 35, the fourth mask pattern 640 may completely cover the first spacer film 142 on the second insulation pattern DI2.

Therefore, the second insulation pattern DI2 may not be exposed by the recess process using the fourth mask pattern 640. The fourth mask pattern 640 on the first region I is equal to that described above referring to FIG. 28, and therefore the detailed description thereof will not be provided.

Referring to FIG. 36, the fifth mask pattern 650 may completely cover the second spacer film 144 on the second insulation pattern DI2.

Therefore, the second insulation pattern DI2 may not be exposed by the recess process using the fifth mask pattern 650. The fifth mask pattern 650 on the first region I is equal to that described above referring to FIG. 31, and therefore the detailed description thereof will not be provided.

The steps described above using FIGS. 33 to 35 and 5 may then be performed. As a result, the semiconductor memory device described above using FIGS. 1 to 4 and 8 may be fabricated.

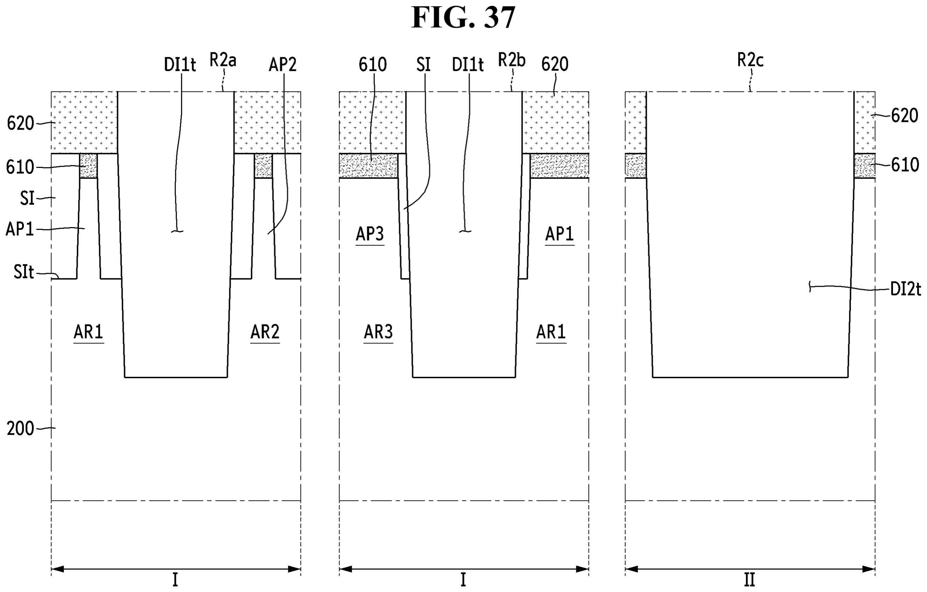

FIGS. 37 to 39 are intermediate step diagrams for explaining the method for fabricating a semiconductor memory device according to example embodiments. For reference, FIG. 37 is an intermediate step diagram for explaining the step after FIG. 21. For convenience of explanation, repeated parts of contents explained above using FIGS. 1 to 34 will be briefly explained or omitted.

Referring to FIG. 37, the first separation trench DIlt and the second separation trench DI2t may be formed at the same level.

For example, the second mask pattern 620 may expose a part of the first mask pattern 610 on the second region II. Accordingly, the first separation trench DIlt and the second separation trench DI2t may be formed simultaneously by an etching process using the second mask pattern 620 as an etching mask. The second mask pattern 620 on the first region I is equal to that described above referring to FIG. 22, and therefore the detailed description thereof will not be provided below.

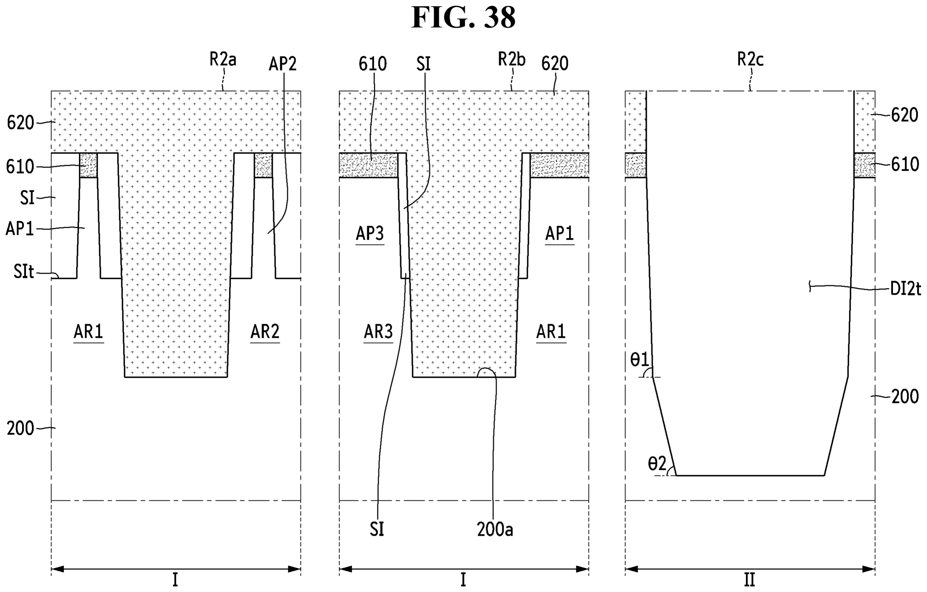

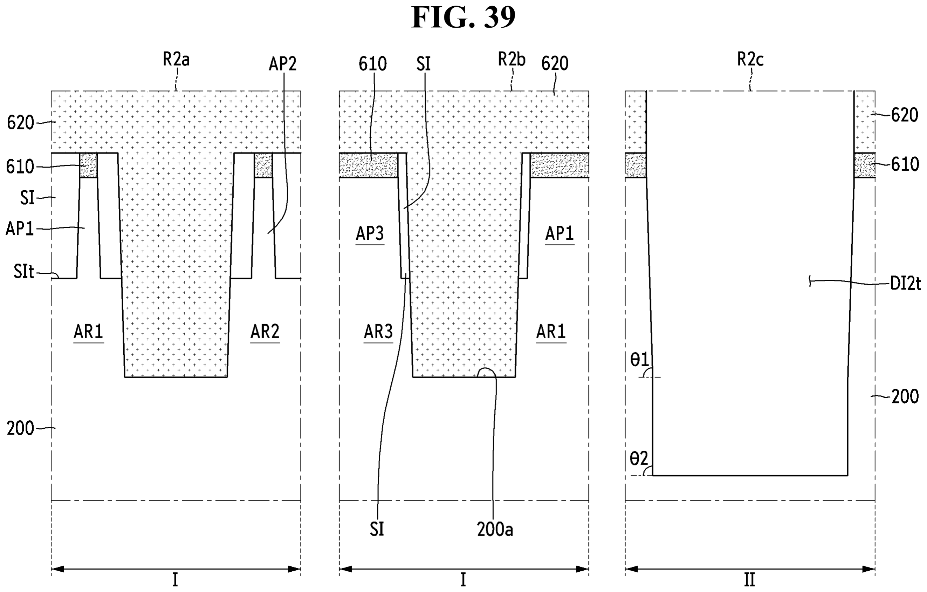

Referring to FIGS. 38 and 39, an additional etching process is performed on the second separation trench DI2t.

For example, an additional etching process may be performed on the second region II of the second substrate 200, by using the third mask pattern 630 as an etching mask. As the additional etching process is performed, the depth at which the second separation trench DI2t is formed may be greater than the depth at which the first separation trench DIlt is formed. The third mask pattern 630 on the first region I is equal to that described above referring to FIG. 23, and therefore the detailed description thereof will not be provided below.

In some embodiments, as shown in FIG. 38, the second outer angle θ2 of the second separation trench DI2t may be smaller than the first outer angle θ1 of the second separation trench DI2t. In some embodiments, as shown in FIG. 39, the second outer angle θ2 of the second separation trench DI2t may be greater than the first outer angle θ1 of the second separation trench DI2t.

Next, the steps described above using FIGS. 24 to 35 and 5 may be performed. Accordingly, the semiconductor memory device described above referring to FIGS. 1 to 4, 9 and 10 may be fabricated.

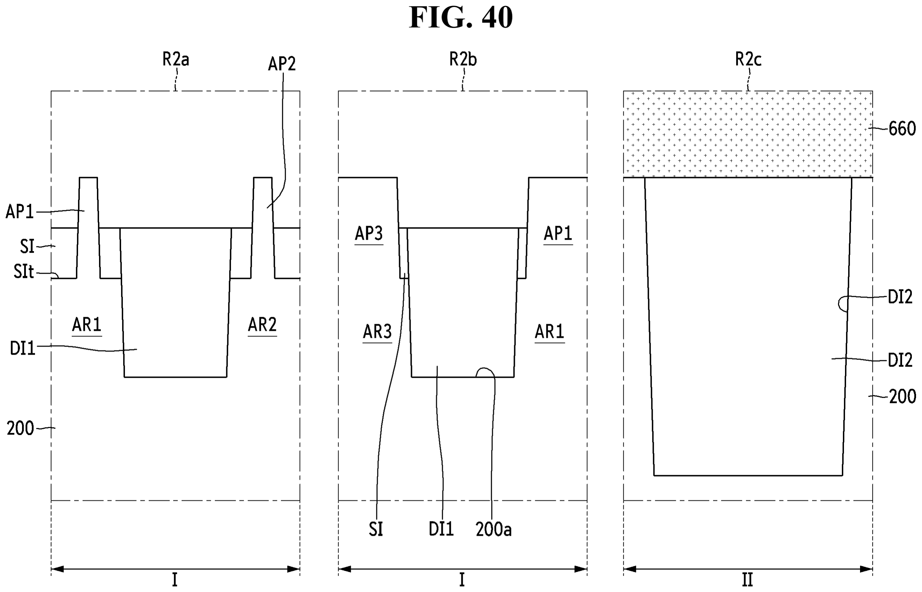

FIG. 40 is an intermediate step diagram for explaining the method for fabricating the same of the semiconductor memory device according to example embodiments. For reference, FIG. 40 is an intermediate step diagram for explaining the steps after FIG. 24. For convenience of explanation, repeated parts of contents explained above using FIGS. 1 to 34 will be simply explained or omitted.

Referring to FIG. 40, a recess process is performed on the field insulation film SI and the first insulation pattern DI1.

In the recess process, the second insulation pattern DI2 may not be recessed. For example, before the recess process is performed, a sixth mask pattern 660 that covers the second insulation pattern DI2 may be formed. In the recess process, the second insulation pattern DI2 may be protected by the sixth mask pattern 660.

Next, the steps described above using FIGS. 26 to 35 and 5 may be performed. Accordingly, the semiconductor memory device described above using FIGS. 1 to 4, 9 and 11 may be fabricated.

While the present inventive concept has been particularly shown and described with reference to exemplary embodiments thereof, it will be understood by those of ordinary skill in the art that various changes in form and details may be made therein without departing from the scope of the present invention as set forth in the following claims.

## Claims

1. A semiconductor memory device comprising:
a memory cell structure (MC) which includes a channel pattern (CH), a bit line (BL) connected to a first portion of the channel pattern (CH), a data storage structure (CAP) connected to a second portion of the channel pattern (CH), and a word line (WL) intersecting the channel pattern (CH) between the first portion and the second portion;
a substrate (200) which faces the memory cell structure (MC) in a first direction, the substrate (200) including a first region (I) and a second region (II) different from each other;
a first insulation pattern (DI1) which defines an active region (AR1 to AR3) inside the first region (I);
an active pattern (AP1 to AP3) which protrudes from the active region (AR1 to AR3);
a gate structure (GS) which intersects the active pattern (AP1 to AP3), on the active pattern (AP1 to AP3);
a second insulation pattern (DI2) inside the second region (II); and
a through via (TV) which extends in the first direction and penetrates the second insulation pattern (DI2).

2. The semiconductor memory device of claim 1, wherein the first insulation pattern (DI1) and the second insulation pattern (DI2) have materially the same compositions.

3. The semiconductor memory device of claim 1 or 2, further comprising:
a spacer (140) which extends along a side face of the gate structure (GS), at least a part of the first insulation pattern (DI1), at least a part of the second insulation pattern (DI2), and a profile of the substrate (200) on the second region (II) protruding from a surface of the second insulation pattern (DI2).

4. The semiconductor memory device of claim 3, wherein a thickness of the spacer (140) on the first insulation pattern (DI1) is equal to a thickness of the spacer (140) on the second insulation pattern (DI2).

5. The semiconductor memory device of any one of claims 1 to 4, wherein each of the first insulation pattern (DI1) and the second insulation pattern (DI2) includes a liner film (102) and a filling insulation film (104) that are sequentially stacked.

6. The semiconductor memory device of claim 5, wherein a thickness of the liner film (102) of the first insulation pattern (DI1) is equal to a thickness of the liner film (102) of the second insulation pattern (DI2).

7. The semiconductor memory device of any one of claims 1 to 6, wherein the substrate (200) includes a first side (200a) facing the memory cell structure (MC), and a second side (200b) opposed to the first side, and
wherein the active pattern (AP1 to AP3) and the gate structure (GS) are disposed on the first side (200a).

8. The semiconductor memory device of claim 7, further comprising:
an input/output pad connected to the through via (TV), on the second side;
a source/drain pattern (SD1 to SD3) connected to the active pattern (AP1 to AP3), on a side face of the gate structure (GS),
wherein the through via (TV) is connected to the source/drain pattern (SD1 to SD3) through a wiring structure (370).

9. The semiconductor memory device of any one of claims 1 to 8, further comprising:
a wiring structure (170, 270 370) on the first and second regions (I, II);
a source/drain pattern (SD1 to SD3) connected to the active pattern (AP1 to AP3),
wherein the through via (TV) is connected to the source/drain pattern (SD1 to SD3) through the wiring structure (170, 270 370).

10. The semiconductor memory device of any one of claims 1 to 7, further comprising:
a source/drain pattern (SD1 to SD3) connected to the active pattern (AP1 to AP3), on a side face of the gate structure (GS); and
an etch stop film (160) which extends along the source/drain pattern (SD1 to SD3), the first insulation pattern (DI1), and the second insulation pattern (DI2),
wherein a thickness of the etch stop film (160) on the first insulation pattern (DI1) is equal to a thickness of the etch stop film (160) on the second insulation pattern (DI2).

11. The semiconductor memory device of any one of claims 1 to 10, further comprising:
a field insulation film (SI) which covers at least a part of a side face of the active pattern (AP1 to AP3), on the active region (AR1 to AR3).

12. The semiconductor memory device of claim 11, wherein the gate structure (GS) is on the active pattern (AP1 to AP3) and on the field insulation film.

13. The semiconductor memory device of any one of claims 1 to 12, wherein a surface of the first insulation pattern (DI1) and a surface of the second insulation pattern (DI2) are coplanar, and/or
wherein a depth of the second insulation pattern (DI2) is greater than a depth of the first insulation pattern (DI1).

14. The semiconductor memory device of claim 1 or 2, wherein:
the active region (AR1 to AR3) comprises a first active region (AR1) and a second active region (AR2), the first insulation pattern (DI1) separating the first active region (AR1) and the second active region (AR2);
the active pattern (AP1 to AP3) comprises a first active pattern (AP1) protruding from the first active region (AR1);
the active pattern (AP1 to AP3) comprises a second active pattern (AP2) which protrudes from the second active region (AR2);
the semiconductor memory device further comprises:
a first source/drain pattern (SD1) which is connected to the first active pattern (AP1), the first source/drain pattern (SD1) having a first conductivity type;
a second source/drain pattern (SD2) which is connected to the second active pattern (AP2), the second source/drain pattern (SD2) having a second conductivity type different from the first conductivity type;
a spacer (140) which extends along at least a part of the first insulation pattern (DI1), at least a part of the second insulation pattern (DI2), and a profile of the substrate (200) on the second region (II) protruding from a surface of the second insulation pattern (DI2); and
an etch stop film (160) which extends along the first source/drain pattern (SD1), the second source/drain pattern (SD2), the spacer (140), the first insulation pattern (DI1), and the second insulation pattern (DI2),
wherein a thickness of the spacer (140) on the first insulation pattern (DI1) is equal to a thickness of the spacer (140) on the second insulation pattern (DI2), and
wherein a thickness of the etch stop film (160) on the first insulation pattern (DI1) is equal to a thickness of the etch stop film (160) on the second insulation pattern (DI2).

15. The semiconductor memory device of claim 14, wherein the spacer (140) includes a first spacer portion (140A) extending along a side face of the first active pattern (AP1), and a second spacer portion (140B) spaced apart from the first spacer portion (140A) and extending along a part of the first insulation pattern (DI1), and
wherein the second spacer portion (140B) has a step.
